# EUROPEAN PATENT APPLICATION

(11) **EP 2 264 782 A1**
(43) Date of publication of application: **22.12.2010**
(21) Application number: 09721520.6
(22) Date of filing: 04.03.2009
(51) Int. Cl.: H01L 31/042

(54) **SOLAR BATTERY MODULE AND METHOD FOR MANUFACTURING SOLAR BATTERY MODULE**

(30) Priority: 17.03.2008 JP 2008068128; 17.03.2008 JP 2008068129
(71) Applicant: Sharp Kabushiki Kaisha, Osaka-shi Osaka 545-8522 (JP)
(72) Inventor: The designation of the inventor has not yet been filed
(74) Representative: Müller - Hoffmann & Partner
(86) International application number: PCT/JP2009/054040
(87) International publication number: WO 2009/116394

(57) **Abstract**

The present invention provides a solar cell module in which at least one portion of a wire (109, 110, 1109, 1110) of a wiring substrate at a side opposite to light receiving surfaces of solar cells (100, 1100) is exposed from a sealing material (118, 1118), as well as a method for manufacturing the solar cell module. Further, the present invention provides a solar cell module in which a conductive wire (1200, 1202) for extracting a current to outside has one end (1200a, 1202a, 1203a, 1204a) electrically connected to a wire (109, 110, 1109, 1110) of a wiring substrate and the conductive wire (1200, 1202) has the other end (1200c, 1202b, 1203b, 1204c) drawn to outside from a sealing material (118, 1118), and at least one portion of a surface of the conductive wire (1200, 1202) between the one end (1200a, 1202a, 1203a, 1204a) of the conductive wire (1200, 1202) and the other end (1200c, 1202b, 1203b, 1204c) of the conductive wire (1200, 1202) is covered with at least one of an insulating base (111, 1111) and the insulating sealing material (118, 1118), as well as a method for manufacturing the solar cell module.

## Description

### TECHNICAL FIELD

The present invention relates to a solar cell module and a method for manufacturing the solar cell module, in particular, a solar cell module allowing for a simplified wiring operation and a method for manufacturing such a solar cell module.

The present invention also relates to a solar cell module and a method for manufacturing the solar cell module, in particular, a solar cell module allowing for a simplified insulating process for a conductive wire and a method for manufacturing such a solar cell module.

### BACKGROUND ART

In recent years, problems of exhaustion of energy resources and global environmental issues such as increasing CO₂ in the atmosphere have driven demands for development of clean energy. In particular, utilization of solar cells for photovoltaic power generation has been developed, been put into practical use, and been expanded as a new energy source.

In an exemplary conventional mainstream solar cell of such solar cells, a monocrystalline or polycrystalline silicon substrate has a surface (light-receiving surface) via which sunlight enters and in which an impurity of conductive type opposite to that of the silicon substrate is diffused to form a pn junction in the vicinity of the light receiving surface. In the silicon substrate, electrodes for one type are formed on the light receiving surface and electrodes for another type are formed on a surface (back surface) opposite thereto.

A plurality of such solar cells configured as above are electrically connected to one another by interconnectors to form a solar cell string. A plurality of such solar cell strings are electrically connected to one another and are thereafter sealed by a sealing material such as a resin to fabricate a solar cell module for photovoltaic power generation.

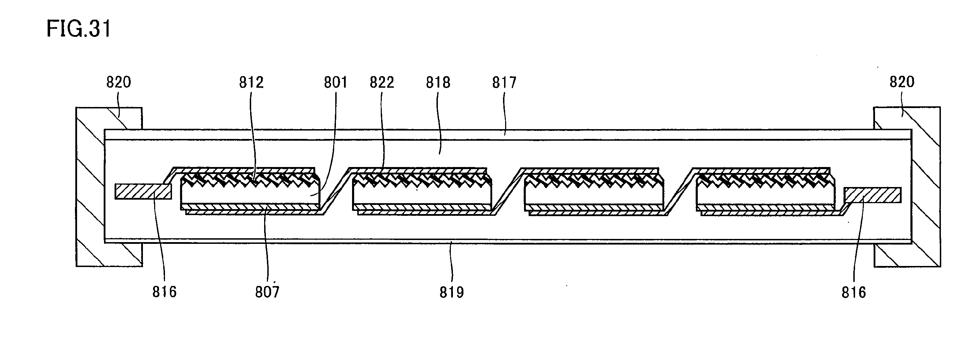

Fig. 31 shows a schematic cross sectional view of one exemplary conventional solar cell module. The conventional solar cell module herein has the following configuration. That is, solar cells each have a silicon substrate 801 that has a light receiving surface provided with a texture structure as well as an anti-reflection film 812 and a light receiving surface electrode (not shown) formed together thereon, and that has a back surface provided with a back-side electrode 807. Such solar cells are connected to one another by interconnectors 822 to form a solar cell string. The solar cell string thus formed is sealed with a sealing material 818 such as a transparent resin. Sealing material 818 with which the solar cell string is sealed has an upper surface on which a glass substrate 817 is provided, has a lower surface on which a weather-resistant film 819 is provided, and has an outer circumference surrounded by an aluminum frame 820. Interconnectors 822 disposed at opposite ends of the solar cell string are provided with connection members 816 connected to other solar cell strings.

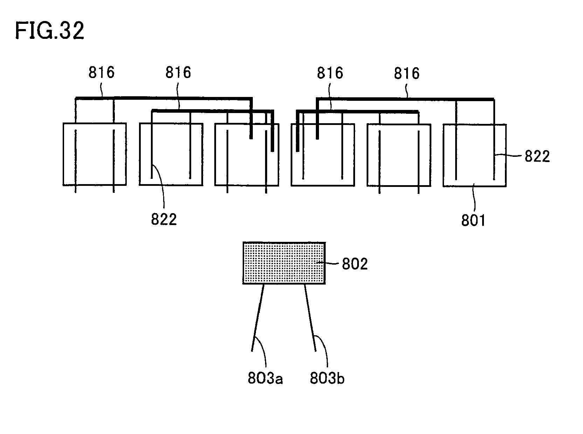

Fig. 32 shows a partial schematic configuration at the back surface side of the solar cell module shown in Fig. 31. Although not shown in the figure, the solar cells are arranged downward in the plane of sheet of Fig. 32 and connected in series with one another. Each row of the solar cells constitutes a solar cell string. Further, the end portions of interconnectors 822 of adjacent solar cell strings are connected to each other via connection members 816. Connection members 816 are drawn around the outer circumference of the solar cell module and are converged into one location. Connection members 816 thus converged into one location are connected to a terminal box 802 including a lead wire 803a, a lead wire 803b, and a by-pass diode (not shown). In this way, a current generated in the solar cell module is extracted to outside by lead wires 803a, 803b.
Patent Document 1: Japanese Patent Laying-Open No. 2005-340362
Patent Document 2: Japanese Patent Laying-Open No. 2007-115915

### DISCLOSURE OF THE INVENTION

### PROBLEMS TO BE SOLVED BY THE INVENTION

In the conventional solar cell module having the above-described structure, for the connection with terminal box 802, connection members 816 need to be drawn around the outer circumference of the solar cell module and be converged into one location. Such an operation of connecting the wires requires time and effort very much, disadvantageously. In addition, in order to prevent connection members 816 from being electrically connected to the back-side electrodes of the solar cells or other connection members 816, an insulating process is necessary such as coating of surfaces of connection members 816 with an insulating member. Furthermore, the insulating process for connection members 816, which are conductive wires, requires time and effort, disadvantageously.

Each connecting member 816 for connecting solar cell strings receives electric power from about ten solar cells, intensively. A connecting member 816 connected to terminal box 802 intensively receives electric power from several ten or hundred solar cells. Hence, connection members 816 need to be securely connected. An operation to achieve such connection requires skilled operators.

In view of the circumstances described above, an object of the present invention is to provide a solar cell module, which has a reduced number of components for a wiring operation in fabricating the solar cell module and allows for a simplified connecting operation so as to achieve reduced manufacturing cost and improved operation efficiency, as well as a method for manufacturing such a solar cell module.

Another object of the present invention is to provide a solar cell module allowing for a simplified insulating process for a conductive wire, as well as a method for manufacturing such a solar cell module.

### MEANS FOR SOLVING THE PROBLEMS

The present invention provides a solar cell module comprising a solar battery structure including a wiring substrate having a wire for electrically connecting solar cells, and a plurality of solar cells disposed on the wire of the wiring substrate and electrically connected to one another, the solar battery structure being disposed in a sealing material such that the solar battery structure has opposite ends in at least one of which a portion of the wire is located at a side opposite to light receiving surfaces of the solar cells, at least one portion of the wire thus located at the side opposite to the light receiving surfaces of the solar cells being exposed from the sealing material.

In the solar cell module of the present invention, the wire preferably has at least one portion including at least one selected from a group consisting of copper, aluminum, and silver.

The solar cell module of the present invention preferably includes a plurality of solar cell strings in each of which the solar cells are connected in series in a row; and a terminal box having an output terminal for extracting to outside a current generated in the solar battery structure, wherein the wire of the wiring substrate includes a solar cell string connecting wire to which the solar cell strings are connected, and an output terminal connecting wire to which the output terminal is connected.

The solar cell module of the present invention preferably includes a by-pass diode connected to the solar cell string connecting wire.

In the solar cell module of the present invention, the output terminal connecting wire and the output terminal are preferably connected to each other by at least one of physical pressure bonding and utilization of a conductive material.

In the solar cell module of the present invention, the output terminal connecting wire and the output terminal are preferably connected to each other through physical pressure bonding employing magnetic force.

In the solar cell module of the present invention, the output terminal connecting wire and the output terminal are preferably connected to each other through physical pressure bonding achieved by fixing the terminal box to the wiring substrate by means of screwing.

In the solar cell module of the present invention, the wiring substrate preferably has an insulating base provided with the wire, and the insulating base is flexible and includes at least one selected from a group consisting of polyethylene terephthalate, polyethylene naphthalate, polyimide, and ethylene vinyl acetate.

In the solar cell module of the present invention, a portion of the wiring substrate at at least one of the opposite ends of the solar battery structure is preferably folded to position the portion of the wire at the side opposite to the light receiving surfaces of the solar cells.

In the solar cell module of the present invention, each of the solar cells is preferably a back-side electrode type solar cell having a back surface, which is opposite to the light receiving surface of the solar cell and is provided with an electrode for p type and an electrode for n type.

The present invention also provides a method for manufacturing any of the solar cell modules described above, including the steps of: electrically connecting the solar cells to the wire of the wiring substrate so as to form the solar battery structure; and disposing the solar battery structure in the sealing material such that the at least one portion of the wire at at least one of the opposite ends of the solar battery structure is exposed from the sealing material at the side opposite to the light receiving surfaces of the solar cells.

The present invention provides a solar cell module in which: a solar battery structure includes an insulating base provided with a wire for electrically connecting solar cells to one another, and a plurality of solar cells disposed on the wire of the insulating base and electrically connected to one another, and the solar battery structure is disposed in an insulating sealing material, a conductive wire for extracting a current to outside has one end electrically connected to the wire and the conductive wire has the other end drawn to outside from the sealing material, and at least one portion of a surface of the conductive wire between the one end of the conductive wire and the other end of the conductive wire is covered with at least one of the insulating base and the sealing material.

Here, in the solar cell module of the present invention, the solar battery structure is preferably disposed in the sealing material such that at least one portion of the insulating base at at least one of opposite ends of the solar battery structure is folded to a side opposite to light receiving surfaces of the solar cells, and the at least one portion of the surface of the conductive wire between the one end of the conductive wire and the other end of the conductive wire is interposed by the folded portion of the insulating base and is therefore covered with the insulating base.

In the solar cell module of the present invention, preferably, the at least one portion of the surface of the conductive wire between the one end of the conductive wire and the other end of the conductive wire is covered with the sealing material, and the other end of the conductive wire is drawn to outside via a notch provided in the sealing material.

In the solar cell module of the present invention, the wire preferably has at least one portion including at least one selected from a group consisting of copper, aluminum, and silver.

In the solar cell module of the present invention, the insulating base is flexible and includes at least one selected from a group consisting of polyethylene terephthalate, polyethylene naphthalate, polyimide, and ethylene vinyl acetate.

In the solar cell module of the present invention, each of the solar cells is a back-side electrode type solar cell having a back surface, which is opposite to a light receiving surface of the solar cell and is provided with an electrode for p type and an electrode for n type.

The present invention also provides a method for manufacturing any of the solar cell modules described above, including the steps of: electrically connecting the solar cells to the wire of the insulating base so as to form the solar battery structure; electrically connecting the one end of the conductive wire to the wire; and sealing the solar battery structure with the sealing material such that at least one portion of the surface of the conductive wire is covered with at least one of the insulating base and the sealing material and the other end of the conductive wire is drawn from the sealing material to outside.

### EFFECTS OF THE INVENTION

According to the present invention, there can be provided a solar cell module allowing for a simplified wiring operation and a method for manufacturing such a solar cell module.

Further, according to the present invention, there can be provided a solar cell module allowing for a simplified insulating process for a conductive wire, and a method for manufacturing such a solar cell module.

### BRIEF DESCRIPTION OF THE DRAWINGS

Fig. 1 is a schematic cross sectional view of an exemplary solar cell module of the present invention.
Fig. 2 is a schematic plan view of an exemplary light receiving surface side of a solar battery structure that will constitute the solar cell module shown in Fig. 1, before folding it.
Fig. 3 is a schematic plan view of an exemplary back surface side of the solar cell module fabricated by folding the solar battery structure, which will constitute the solar cell module shown in Fig. 1, and sealing it with a sealing material.
Fig. 4 is a schematic plan view showing the back surface of a back-side electrode type solar cell used in the solar cell module shown in Fig. 1.
Fig. 5 is a schematic plan view of a wiring substrate used in the solar cell module shown in Fig. 1.
Fig. 6 is a schematic cross sectional view of the solar battery structure, in which the back-side electrode type solar cell having the back surface shown in Fig. 4 is electrically connected to the wiring substrate shown in Fig. 5.
Fig. 7(a)-(c) is a schematic cross sectional view illustrating an exemplary method for manufacturing the solar cell module shown in Fig. 1.
Fig. 8 is a schematic cross sectional view showing an exemplary solar battery structure used in the solar cell module of the present invention.
Fig. 9 is a schematic partial cross sectional view of an exemplary solar cell module of the present invention, in which magnetic force between a magnet and a magnetic body is employed in connecting an output terminal connecting wire of the wiring substrate to an output terminal of a terminal box by means of physical pressure bonding.
Fig. 10 is a schematic partial cross sectional view of the solar cell module shown in Fig. 9, taken along a direction of a shorter side thereof.
Fig. 11 is a schematic perspective exploded view of the solar cell module shown in Fig. 10.
Fig. 12 is a schematic partial cross section of another exemplary solar cell module of the present invention, taken along a direction of a shorter side thereof.
Fig. 13 is a schematic perspective exploded view of the solar cell module shown in Fig. 12.
Fig. 14 is a schematic cross sectional view of an exemplary output terminal of the terminal box used in the present invention.
Fig. 15 is a schematic diagram of another exemplary output terminal of the terminal box used in the present invention.
Fig. 16 is a schematic cross sectional view of still another exemplary output terminal of the terminal box used in the present invention.
Fig. 17 is a schematic plan view of another exemplary back surface side of the solar cell module fabricated by folding the solar battery structure, which will constitute the solar cell module shown in Fig. 1, and sealing it with the sealing material.
Fig. 18 is a schematic plan view of another exemplary light receiving surface side of the solar battery structure, which will constitute the solar cell module of the present invention, before folding it.
Fig. 19 is a schematic plan view of an exemplary back surface side of the solar cell module fabricated by folding the solar battery structure shown in Fig. 18 and sealing it with the sealing material.
Fig. 20 is a schematic plan view of another exemplary back surface side of the solar cell module fabricated by folding the solar battery structure shown in Fig. 18 and sealing it with the sealing material.
Fig. 21 is a schematic cross sectional view of another exemplary solar cell module of the present invention.
Fig. 22 is a schematic cross sectional view of the solar cell module at an inner portion relative to the cross section shown in Fig. 21.
Fig. 23 is a schematic plan view showing an exemplary back surface side before folding an insulating base of the solar battery structure used in the solar cell module of the present invention and after sealing it with the sealing material.
Fig. 24 is a schematic plan view of the back surface of an exemplary back-side electrode type solar cell used in the solar cell module of the present invention.
Fig. 25 is a schematic plan view of a wiring substrate used in the solar cell module of the present invention.
Fig. 26 is a schematic cross sectional view of the solar battery structure, in which the back-side electrode type solar cell having the back surface shown in Fig. 24 is electrically connected to the wiring substrate shown in Fig. 25.
Fig. 27 is a schematic plan view of an exemplary light receiving surface side of the solar battery structure, which will constitute the solar cell module of the present invention, before folding it.
Fig. 28(a)-(c) is a schematic cross sectional view illustrating an exemplary method for manufacturing the solar cell module of the present invention.
Fig. 29 is a schematic plan view when viewing a portion of an exemplary solar cell module of the present invention from the light receiving surface side.
Fig. 30 is a schematic plan view when viewing the portion of the solar cell module of Fig. 29 from the back surface side.
Fig. 31 is a schematic cross sectional view of an exemplary conventional solar cell module.
Fig. 32 is a schematic diagram of a portion of the solar cell module of Fig. 31 at the back surface side thereof.

### DESCRIPTION OF THE REFERENCE SIGNS

100: back-side electrode type solar cell; 101, 801: silicon substrate; 102: anti-reflection film; 103: passivation film; 104: n type region, 105: p type region; 106: electrode for n type; 107: electrode for p type; 109: wire for n type; 110: wire for p type; 111: insulating base; 112: slit; 113: connecting wire; 114a, 114b, 114c, 114d, 115a, 115b, 115c: wire end; 117: transparent base; 118: sealing material; 119: back-side base; 120: frame body; 121: bar; 300a, 300b, 300c: diode; 301: opening; 302, 302a, 302b: terminal box; 303a, 303b, 803a, 803b: lead wire; 304: magnetic body; 305: magnet; 310a, 310b: output terminal; 416: screw receiving member; 420a, 420b: lead wire fixing member; 421: pin; 422: screw; 423: filler; 425: through hole; 430: terminal box cover member; 501: support; 502: elastic body; 503: cover portion; 504: spring; 505: pressure bonding portion; 812: anti-reflection film; 807: back-side electrode; 822: interconnector; 818: sealing material; 817: glass substrate; 819: weather-resistant film; 820: aluminum frame; 816: connecting member; 1100: back-side electrode type solar cell; 1101: silicon substrate; 1102: anti-reflection film; 1103: passivation film; 1104: n type region; 1105: p type region; 1106: electrode for n type; 1107: electrode for p type; 1109: wire for n type; 1110: wiring for p type; 1111: insulating base; 1112: slit; 1113: connecting wire; 1114a, 1114b, 1114c, 1114d, 1115a, 1115b, 1115c: wire end; 1117: transparent base; 1118: sealing material; 1119: back-side base; 1120: frame body; 1121: bar; 1200, 1202: conductive wire; 1200a, 1202a, 1203a, 1204a: conductive wire's one end; 1200b, 1204b: conductive wire's intermediate portion; 1200c, 1202b, 1203b, 1204c: conductive wire's other end; 1201a, 1201b: adhering member; 1300a, 1300b, 1300c: notch; 801: silicon substrate; 802: terminal box; 803a, 803b: lead wire; 807: back-side electrode; 812: anti-reflection film; 816: conductive wire; 817: glass substrate; 818: sealing material; 819: weather-resistant film; 820: aluminum frame; 822: interconnector.

### BEST MODES FOR CARRYING OUT THE INVENTION

The following describes embodiments of the present invention. It should be noted that the same reference characters denote the same or corresponding portions in figures of the present invention.

### First Embodiment

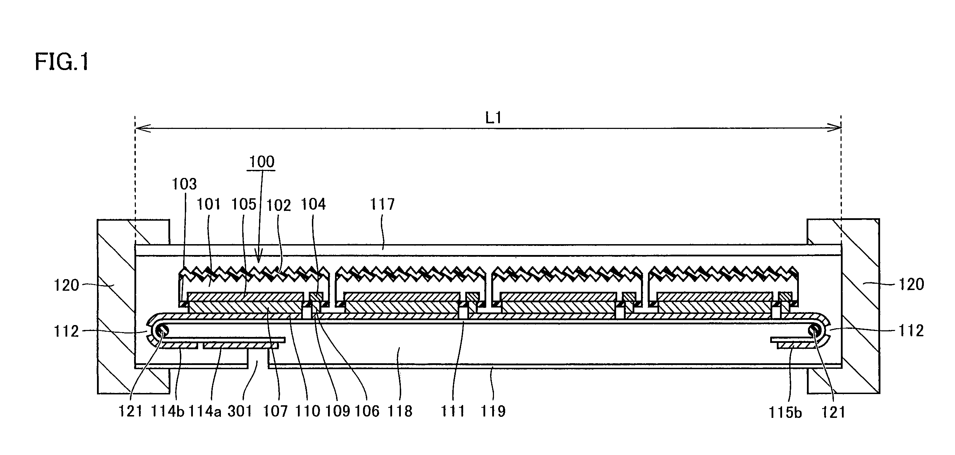

Fig. 1 shows a schematic cross sectional view of one exemplary solar cell module of the present invention. The solar cell module of the present invention has a back-side electrode type solar cell 100 configured as follows, for example. That is, a p type or n type silicon substrate 101 has a back surface on which a passivation film 103 is formed. At the surface thereof exposed from passivation film 103, an n type region 104 and a p type region 105 are formed. On n type region 104, an electrode 106 for n type is formed, whereas on p type region 105, an electrode 107 for p type is formed. Silicon substrate 101 has a light receiving surface on which an anti-reflection film 102 is formed. The light receiving surface of silicon substrate 101 has a texture structure.

Electrode 106 for n type and electrode 107 for p type in back-side electrode type solar cell 100 are electrically connected respectively to a wire 109 for n type and a wire 110 for p type on an insulating base 111 of a wiring substrate. An electrode 106 for n type in one of adjacent back-side electrode type solar cells 100 is electrically connected to an electrode 107 for p type in the other of adjacent back-side electrode type solar cells 100, whereby adjacent back-side electrode type solar cells 100 are connected in series to constitute a solar battery structure. It is preferable to provide, on insulating base 111, a solar cell string connecting wire for connecting solar cell strings each constituted by back-side electrode type solar cells 100 connected in series in one row, and an output terminal connecting wire for connecting an output terminal within the terminal box as described below. The wiring substrate can be formed by, for example, adhering a metal foil onto insulating base 111, forming an etching protection resist of a desired shape on the metal foil, etching the metal foil's portion exposed from the etching protection resist, and thereafter removing the etching protection resist.

The solar battery structure is disposed in a sealing material 118 provided between a transparent base 117 made of for example glass and a back-side base 119 formed of a weather-resistant film or the like. Insulating base 111 of the wiring substrate in the solar battery structure has folded opposite ends located in a direction in which back-side electrode type solar cells 100 constituting the solar cell string are connected. In the present invention, any material can be used for sealing material 118 without particular limitations. For example, a transparent resin such as EVA (ethylene vinyl acetate) can be used therefor.

By folding the opposite ends of insulating base 111 of the wiring substrate in the solar battery structure, wire ends 114a, 114b, 115b are disposed at a side opposite to the light receiving surface of back-side electrode type solar cell 100. Of these wire ends, wire end 114a is exposed to the outside from an opening 301 provided at the back surface of sealing material 118, and is electrically connectable to an output terminal for extracting a generated current from the solar cell module to the outside. Further, a frame body 120 made of aluminum or the like is provided to surround the outer circumferences of transparent base 117, sealing material 118, and back-side base 119 each sealing the solar battery structure, thereby fitting them in frame body 120.

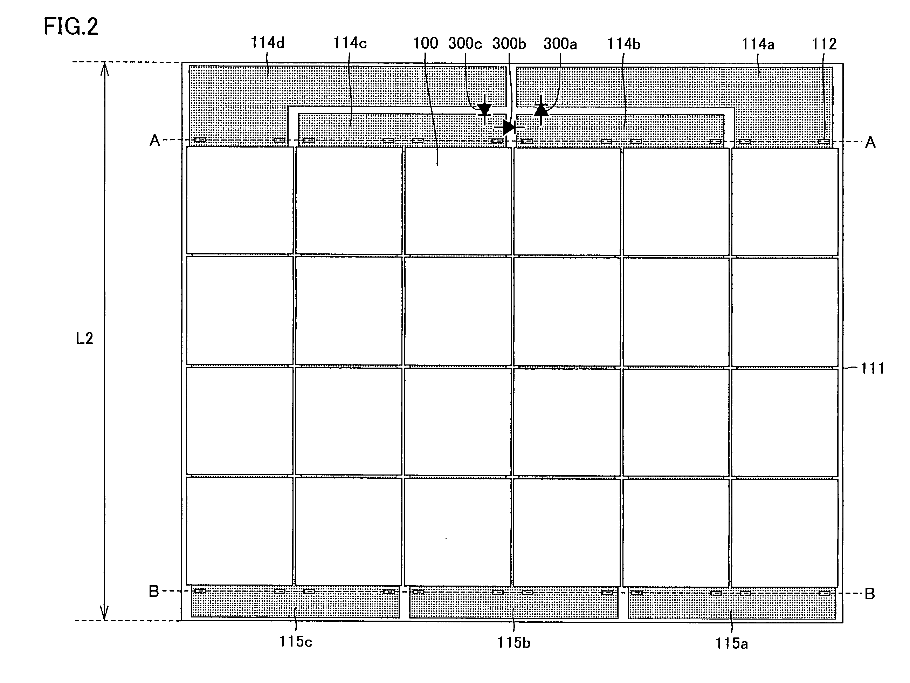

Fig. 2 shows a schematic plan view of one exemplary light receiving surface side before folding the solar battery structure that will constitute the solar cell module shown in Fig. 1. In this example, twenty four back-side electrode type solar cells 100 are disposed 6 in column × 4 in row on the wires of the wiring substrate to constitute the solar battery structure. The solar battery structure is folded along a broken line A-A and a broken line B-B both corresponding to slits 112 provided at the ends of the wiring substrate, and the solar battery structure is sealed with the sealing material, thus obtaining the solar cell module having the configuration shown in Fig. 1.

Here, solar cells 100 arranged between wire end 114a and wire end 115a, between wire end 115a and wire end 114b, between wire end 114b and wire end 115b, between wire end 115b and wire end 114c, between wire end 114c and wire end 115c, and between wire end 115c and wire end 114d are electrically connected to their adjacent solar cells 100 in series. It should be noted that in this example, four back-side electrode type solar cells 100 connected in series in a direction of L2 shown in Fig. 2 and arranged in a row constitutes one solar cell string. Further, in this example, each of wire end 114b, wire end 114c, wire end 115a, wire end 115b, and wire end 115c corresponds to the above-described solar cell string connecting wire.

In order to reduce series resistance in the solar battery structure, each of the wires preferably has a large cross section in the solar battery structure. In the case where each of the wires is widen in width to have a sufficiently large cross section, for example, before the folding, the solar battery structure may have length L2 longer than the solar cell module's length L1 excluding the thickness of the frame. Length L2 is a length in the direction in which back-side electrode type solar cells 100 of the solar battery structure shown in Fig. 2 are connected (direction of L2 shown in Fig. 2) whereas length L1 is a length in the direction in which back-side electrode type solar cells 100 shown in Fig. 1 are connected (the direction of a shorter side of the solar cell module).

Even in such a case, however, in the present invention, the opposite ends of insulating base 111 of the wiring substrate in the solar battery structure are folded to the side opposite to the light receiving surface of each back-side electrode type solar cell 100 and the solar battery structure is then sealed to fabricate the solar cell module, so design for wiring can be done without depending on the shape of the solar cell module. This leads to suffcient reduction of the series resistance in the solar battery structure, thus achieving improved characteristics of the solar cell module such as F.F.

In a solar cell module, when a shadow is cast on a part of its solar cells and the solar cells thus receiving no sunlight do not generate power, a reverse current may flow from solar cells generating power to the solar cells generating no power so as to break the solar cells. In order to prevent such a reverse current, normally a diode (by-pass diode) is provided in the terminal box. When a current flows in such a by-pass diode, the by-pass diode emits heat. Hence, terminal boxes having improved heat radiation characteristics are being developed. Since insulating base 111 of the wiring substrate is folded to allow for large areas for the wires in the present invention, such by-pass diodes having been provided in a terminal box conventionally are preferably provided at wires to achieve a high heat radiation characteristic.

In this example, a by-pass diode 300a is connected between wire end 114a and wire end 114b, a by-pass diode 300b is connected between wire end 114b and wire end 114c, and a by-pass diode 300c is connected between wire end 114c and wire end 114d. It should be noted that in the present invention, conventionally known diodes (by-pass diodes) can be used as these by-pass diodes, for example.

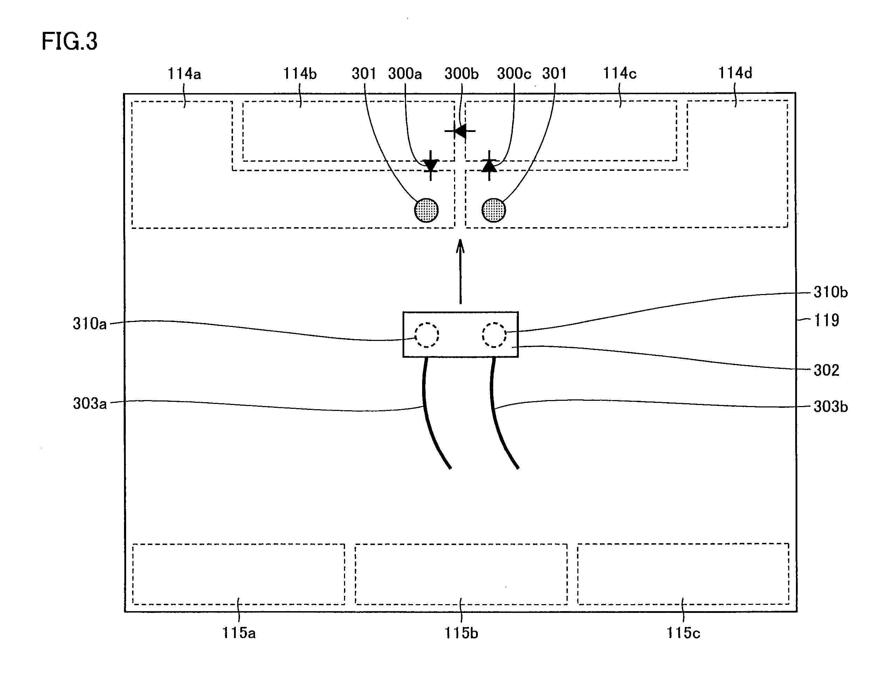

Fig. 3 shows a schematic plan view of one exemplary back surface side of the solar cell module fabricated by folding the solar battery structure that will constitute the solar cell module shown in Fig. 1 and sealing it with the sealing material. In this example, back-side base 119 has portions located at the opposite ends of the solar cell module and removed together with portions of the sealing material located at an inner side relative to back-side base 119, thus providing circular openings 301 from which the surface of wire end 114a and the surface of wire end 114d at the opposite ends of the solar cell module are exposed to the outside.

To the surfaces of wire end 114a and wire end 114d thus exposed to the outside, terminal box 302 containing lead wires 303a, 303b and output terminals 310a, 310b is attached and is electrically connected accordingly. In this way, a current generated by the solar cell module irradiated with sunlight can be extracted to the outside via lead wires 303a, 303b.

As such, in the solar cell module of the present invention, a current can be readily extracted to the outside by attaching the output terminals to the wire ends exposed to the outside and provided on the wiring substrate. Thus, unlike the conventional one shown in Fig. 32, no dedicated connecting members 816 need to be used. Accordingly, such several connecting members do not need to be drawn around the outer circumference of the solar cell module and be converged into one location for connection with the terminal box, unlike the conventional one. Further, no insulating process for the surfaces of connecting members does not need to be performed to prevent the connecting members from being electrically connected to one another. Accordingly, in the solar cell module of the present invention, the wiring operation can be greatly simplified as compared with that in the conventional one. Furthermore, in the solar cell module of the present invention, no connecting members need to be formed, thus achieving reduced manufacturing cost.

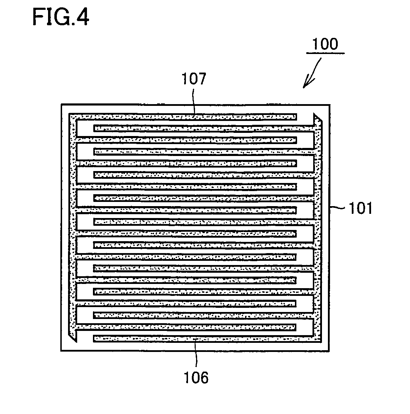

Fig. 4 shows a schematic plan view showing the back surface of each back-side electrode type solar cell 100 used in the solar cell module shown in Fig. 1. Here, each of electrode 106 for n type and electrode 107 for p type is formed on the back surface of silicon substrate 101 in the form of a comb. Electrode 106 for n type and electrode 107 for p type are provided so that their comb tooth are engaged with one another and are positioned alternately. Here, each of electrode 106 for n type and electrode 107 for p type is preferably formed of a metal material, in particular, a material including silver.

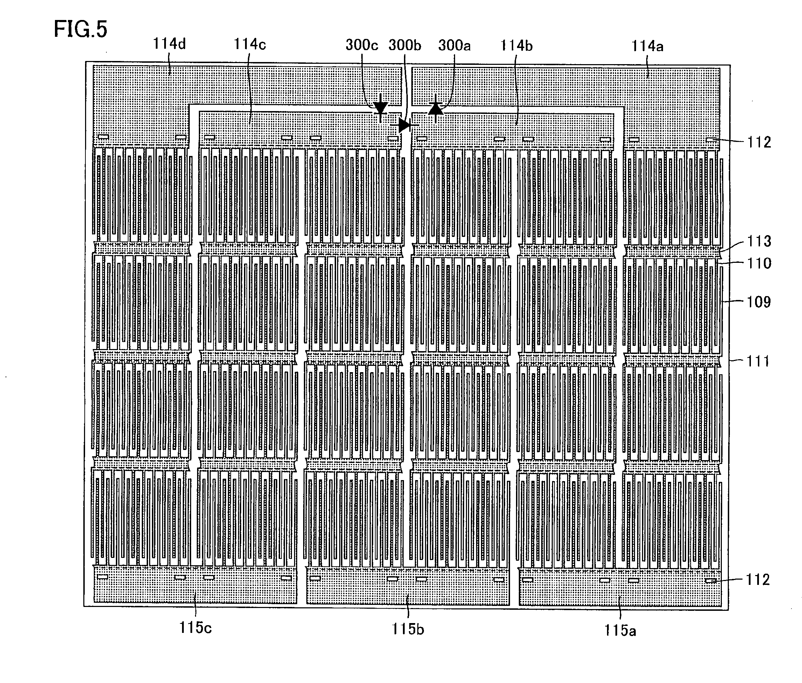

Fig. 5 shows a schematic plan view of insulating base 111 of the wiring substrate used in the solar cell module shown in Fig. 1. Here, insulating base 111, provided with wire 109 for n type and wire 110 for p type, includes a connecting wire 113 for electrically connecting wire 109 for n type to wire 110 for p type. Wire 109 for n type is electrically connected to electrode 106 for n type in back-side electrode type solar cell 100 whereas wire 110 for p type is electrically connected to electrode 107 for p type.

Further, wire 110 for p type and wire 109 for n type located at the ends of the wiring substrate are electrically connected to any of wire end 114a, wire end 114b, wire end 114c, wire end 114d, wire end 115a, wire end 115b, and wire end 115c.

Further, wire ends 114a, 114b, 114c, 114d and wire ends 115a, 115b, 115c are provided with slits 112, which are openings for positioning.

It should be noted that in Fig.5, the respective regions of wire 109 for n type, wire 110 for p type, connecting wire 113, wire ends 114a, 114b, 114c, 114d, and wire ends 115a, 115b, 115c are divided by broken lines but the way of dividing is not limited to the one shown in Fig. 5.

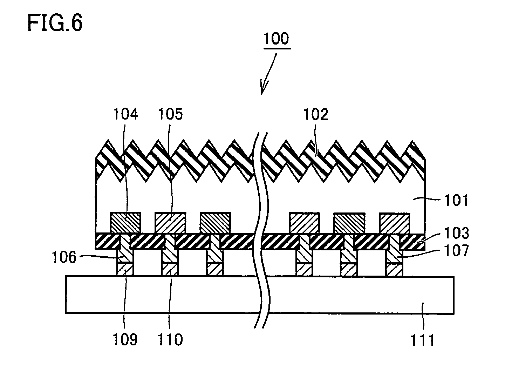

Fig. 6 shows a schematic cross sectional view of the solar battery structure in which each back-side electrode type solar cell 100 having the back surface shown in Fig. 4 is electrically connected to the wiring substrate shown in Fig. 5.

Here, electrode 106 for n type in back-side electrode type solar cell 100 is in contact with and is electrically connected to wire 109 for n type in the wiring substrate whereas electrode 107 for p type in back-side electrode type solar cell 100 is in contact with and is electrically connected to wire 110 for p type in the wiring substrate.

As such, in the present invention, by attaching the wiring substrate onto the back surface of back-side electrode type solar cell 100, electric connection therebetween can be achieved. Accordingly, unlike the connection in the conventional solar cells, no interconnectors need to be drawn from the light receiving surface to the back surface, thereby achieving reduced load on back-side electrode type solar cell 100 upon fabricating the solar cell module. Accordingly, back-side electrode type solar cell 100 is less likely to be cracked. Since the present invention thus allows for reduced load on back-side electrode type solar cell 100 upon fabricating the solar cell module, back-side electrode type solar cell 100 can be thinner (the thickness of silicon substrate 101 can be 200 µm or smaller).

Further, degree of freedom in design for wiring in the wiring substrate is improved by folding, to the side opposite to the light receiving surface of back-side electrode type solar cell 100, the ends of insulating base 111 of the wiring substrate where wire ends 114a, 114b, 114c, 114d and wire ends 115a, 115b, 115c are formed and then by sealing the solar battery structure with the sealing material. In this way, the wire ends have large widths and thus have large cross sections, thereby reducing series resistance between back-side electrode type solar cells 100. Thus, a solar cell module with a high F.F. can be fabricated.

In order to reduce the series resistance between back-side electrode type solar cells 100 by providing the wire ends with large widths, a conductive member may be electrically connected to each of wire ends 114a, 114b, 114c, 114d and wire ends 115a, 115b, 115c, at which the direction in which back-side electrode type solar cells 100 are connected is turned. As the conductive member, any member can be used without particular limitations as long as it is made of a material having conductivity, for example, a conventionally known interconnector having been used in the field of solar cell may be used.

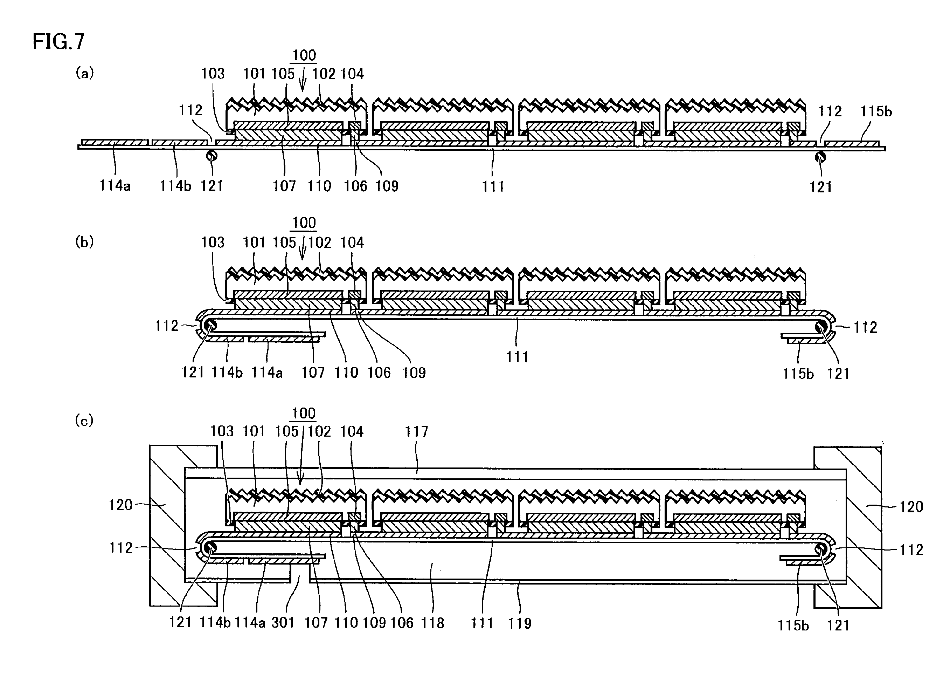

The following describes an exemplary method for manufacturing the solar cell module shown in Fig. 1, with reference to schematic cross sectional views of Fig. 7(a)-Fig.7(c).

First, as shown in Fig. 7(a), the solar battery structure is fabricated in the manner described above, and insulating bars 121 are provided below slits 112 formed at the opposite ends of the solar battery structure. As insulating bars 121, there can be used bars each made of an insulating material such as acrylic and having a diameter of approximately 1-2 mm, for example. For prevention of cracks taking place in back-side electrode type solar cells 100, bars 121 are preferably provided, for example, outside back-side electrode type solar cells 100 disposed at the ends located in the direction in which back-side electrode type solar cells 100 are connected, as shown in Fig. 7(a). Slits 112 are preferably formed to have a size that has no influence over resistance of the wires in the wiring substrate.

Next, as shown in Fig. 7(b), the portions of insulating base 111 of the wiring substrate at the opposite ends of the solar battery structure are folded around bars 121 to the side opposite to the light receiving surface of back-side electrode type solar cell 100. In order to avoid waste in an occupation rate of back-side electrode type solar cells 100 in the light receiving surface of the solar cell module, it is preferable to install back-side electrode type solar cells 100 so that portions other than back-side electrode type solar cells 100 are not exposed to the light receiving portion of the solar cell module.

Further, in the embodiment described herein, bars 121 are provided at the locations of slits 112 as the folding locations, and the portions of insulating base 111 of the wiring substrate at the ends of the solar battery structure are folded around bars 121. In the present invention, however, insulating base 111 may be folded without bars 121 at the locations of slits 112 as the folding locations, to the side opposite to the light receiving surface of back-side electrode type solar cell 100. However, in the case where it is folded without using bars 121, the folded portions provide acute angles, which may break the wires. In contrast, when folding around bars 121, load on the folded portions is reduced. Thus, it is preferable to use bars 121 and fold it around bars 121. It should be noted that bars 121 may be removed upon sealing the solar battery structure or may be remained therein.

After the portions of insulating base 111 of the wiring substrate at the opposite ends of the solar battery structure are thus folded to the side opposite to the light receiving surface of back-side electrode type solar cell 100, the solar battery structure is sealed with sealing material 118 such as a transparent resin between transparent base 117 such as glass and back-side base 119 such as a weather-resistant film, as shown in Fig. 7(c). Portions of sealing material 118 and back-side base 119 are removed in advance to form openings 301. From opening 301, the surface of wire end 114a is exposed. Thereafter, frame body 120 made of aluminum or the like is provided to surround the outer circumferences of transparent base 117, sealing material 118, and back-side base 119, thereby fitting them in frame body 120. In this way, the solar cell module having the configuration shown in Fig. 1 is fabricated.

It should be noted that by-pass diodes 300a, 300b, 300c may be attached to the wire ends of the wiring substrate before the sealing with sealing material 118, or the by-pass diodes may be attached thereto after removing respective portions of sealing material 118 and back-side base 119 in advance to provide openings at locations corresponding to the attachment locations of the by-pass diodes and then sealing the solar battery structure. As such, attaching the by-pass diodes onto the wire ends of the wiring substrate is a more simplified way of attaching as compared with attaching the by-pass diodes to a small terminal box, whereby operation stability is improved and a high heat radiating characteristic can be expected.

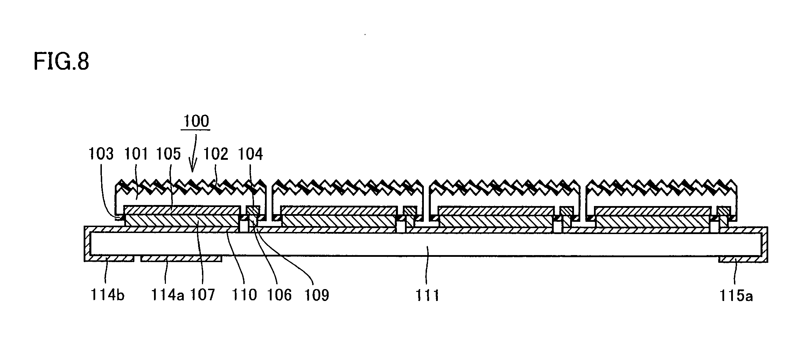

Explained in the above description is the case where at least one flexible film selected from a group consisting of PET (polyethylene terephthalate), PEN (polyethylene naphthalate), polyimide, and ethylene vinyl acetate is used as insulating base 111 of the wiring substrate, but in the present invention, an inflexible base can be used as insulating base 111 of the wiring substrate, such as a glass substrate, a glass epoxy substrate, and a paper-phenolic substrate. In the case where insulating base 111 of the wiring substrate is not flexible, the wires may be formed for example to extend along insulating base 111 as shown in Fig. 8 so that wire ends 114a, 114b, 114c, 114d and wire ends 115a, 115b, 115c exist on the back surface of insulating base 111 (the surface opposite to the surface facing the light receiving surface of the solar cell).

Further, it is preferable to use a metal material including at least one selected from a group consisting of silver, copper, and aluminum for each of the wire members described above, i.e., wire 109 for n type, wire 110 for p type, connecting wire 113, wire ends 114a, 114b, 114c, 114d, and wire ends 115a, 115b, 115c.

Further, in the description above, the connection between the surface of wire end 114a and output terminal 310a provided in terminal box 302, and the connection between the surface of wire end 114d and the output terminal 310b provided in terminal box 302 are achieved by, for example, at least one of physical pressure bonding and utilization of a conductive material.

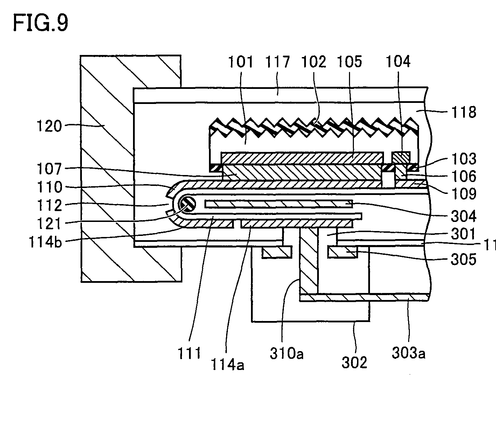

An exemplary method for achieving the connections by physical pressure bonding is to bring output terminal 310a in terminal box 302 and the surface of wire end 114a into contact with each other and fix them to each other, using magnetic force between a magnet 305 and a magnetic body 304 such as an iron plate as shown in Fig. 9. The solar cell module having such a configuration can be fabricated, for example, as follows.

First, for example, magnetic body 304, such as an iron plate, having a thickness of approximately 1 mm is interposed by each of the folded portions of insulating base 111 of the wiring substrate. Then, the portions of sealing material 118 and back-side base 119 are removed to provide the openings in the portion corresponding to the installation location of the terminal box 302. In this way, output terminal connecting wires included in wire ends 114a, 114d of the wiring substrate are exposed in the solar battery structure sealed. Then, terminal box 302, which is provided with magnet 305 at its bottom portion, is installed on the exposed output terminal connecting wires, whereby terminal box 302 is attached to the wiring substrate by means of magnetic force between magnet 305 of terminal box 302 and magnetic body 304 at the folded portion of insulating base 111 of the wiring substrate. Thus, according to this configuration, only by installing terminal box 302 thereon, output terminals 310a, 310b of terminal box 302 and the output terminal connecting wires can be electrically connected to one another. In this way, terminal box 302 can be attached readily and securely thereto irrespective of levels of skill of operators. It should be noted that an exemplary material usable as magnetic body 304 is a material including at least one selected from a group consisting of iron, nickel, and cobalt. As magnet 305, a magnet having a magnetic field may be used but it is preferable to use a permanent magnet in consideration of long term reliability of the solar cell module. As the permanent magnet, it is particularly preferable to use a ferrite magnet, which is less demagnetized. In order to improve reliability in electric connection between the output terminals of terminal box 302 and the output terminal connecting wires, it is preferable to fix terminal box 302 and back-side base 119 to each other using an adhesive agent or the like.

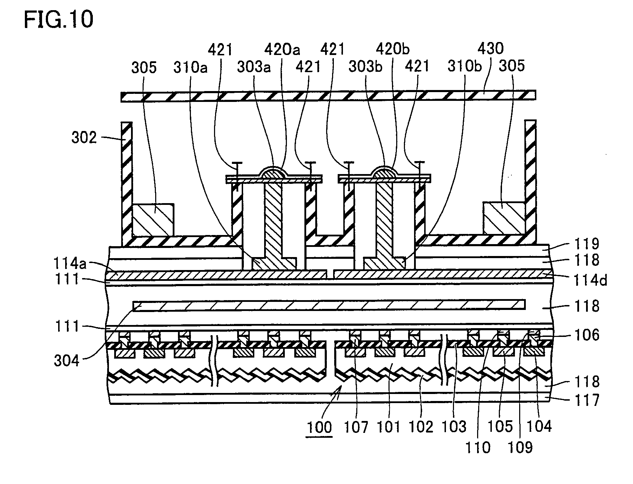

Fig. 10 schematically shows a partial cross section of the solar cell module shown in Fig. 9, taken along the longitudinal direction thereof (direction orthogonal to the direction of the shorter side of the solar cell module).

Here, the solar battery structure is sealed with sealing material 118 between insulating base 111 of the wiring substrate and transparent base 117, wire 109 for n type in the wiring substrate is electrically connected to electrode 106 for n type in the solar battery structure, and wire 110 for p type in the wiring substrate is electrically connected to electrode 107 for p type in the solar battery structure. The opposite ends of insulating base 111 of the wiring substrate are folded so that wire end 114a and wire end 114d are located in the backside of the insulating base 111. Further, magnetic body 304 is provided at the folded portion of insulating base 111 so as to be positioned at a location corresponding to the installation location of terminal box 302.

The surface of wire end 114a corresponding to the output terminal connecting wire of the wiring substrate is brought into contact with and is therefore electrically connected to output terminal 310a of terminal box 302. The surface of wire end 114d corresponding to the output terminal connecting wire of the wiring substrate is brought into contact with and is therefore electrically connected to output terminal 310b of terminal box 302. Further, output terminal 310a is electrically connected to lead wire 303a, and output terminal 310b is electrically connected to lead wire 303b. It should be noted that output terminal 310a and lead wire 303a are fixed by covering lead wire 303a with a lead wire fixing member 420a and then fixing lead wire fixing member 420a to terminal box 302 using a pin 421. Likewise, output terminal 310b and lead wire 303b are fixed by covering lead wire 303b with a lead wire fixing member 420b and then fixing lead wire fixing member 420b to terminal box 302 using a pin 421.

Terminal box 302 has ends respectively provided with magnets 305. Magnetic force between each of magnets 305 in terminal box 302 and magnetic body 304 in the wiring substrate allows terminal box 302 to be fixed to the wiring substrate.

Further, portions other than the connection portion of wire end 114a of the wiring substrate (i.e., the output terminal connecting wire) with output terminal 310a and portions other than the connection portion of wire end 114d (i.e., the output terminal connecting wire) with output terminal 310b are covered with sealing material 118. On sealing material 118, back-side base 119 is provided. Terminal box 302 is attached to the wiring substrate in contact with back-side base 119. It is preferable to fix terminal box 302 and back-side base 119 to each other using an adhesive agent or the like.

The upper surface of terminal box 302 is covered with a terminal box cover member 430 but terminal box 302 is preferably filled with a resin in order to effectively prevent deterioration of the output terminal connecting wires and the like by moisture.

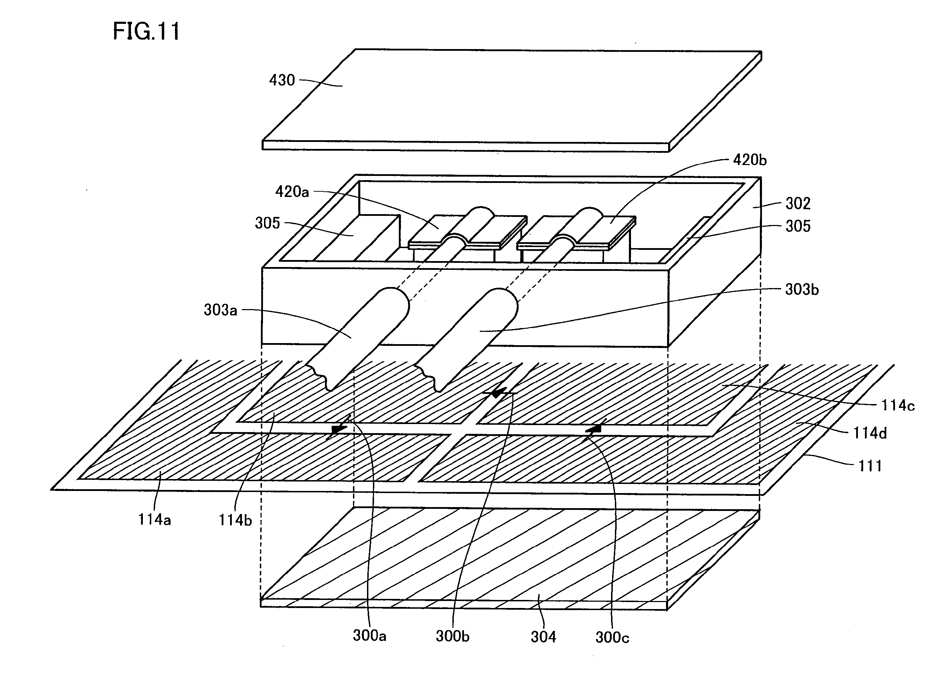

Here, magnetic body 304 sealed with sealing material 118 in the wiring substrate is for example provided below insulating base 111 so that magnets 305 in terminal box 302 correspond to the opposite ends of magnetic body 304 as shown in a schematic perspective view of Fig. 11.

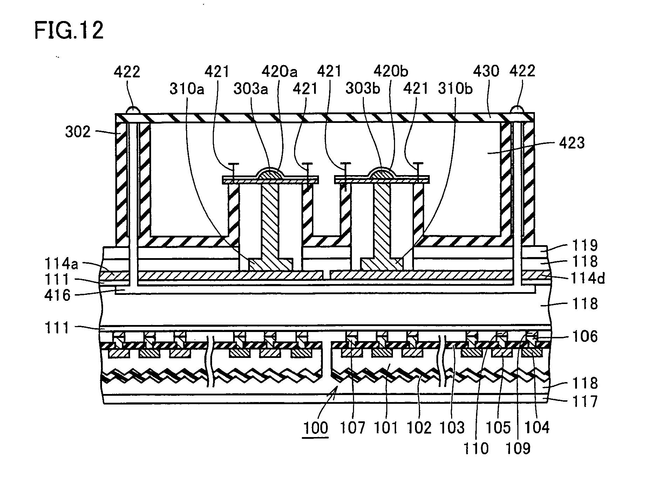

Fig. 12 schematically shows a partial cross section of another exemplary solar cell module of the present invention, taken along the longitudinal direction thereof (direction orthogonal to the direction of the shorter side of the solar cell module). A feature of this solar cell module lies in that the solar cell module is provided with a screw receiving member 416 which has a portion sealed with sealing material 118 of the wiring substrate and having four corners provided with projecting portions extending upward, and that screws 422 are put into the projecting portions of screw receiving member 416 to attach terminal box 302 thereto. Terminal box 302 is filled with a filler 423 such as a resin.

Namely, in the solar cell module configured as shown in Fig. 12, screws 422 are put into screw receiving member 416 penetrating portions of terminal box 302, thereby bringing output terminals 310a, 310b in terminal box 302 into contact with the surfaces of wire ends 114a, 114d corresponding the output terminal connecting wires of the wiring substrate. In this way, output terminals 310a, 310b and the output terminal connecting wires are in contact with and are therefore electrically connected to one another by physical pressure bonding.

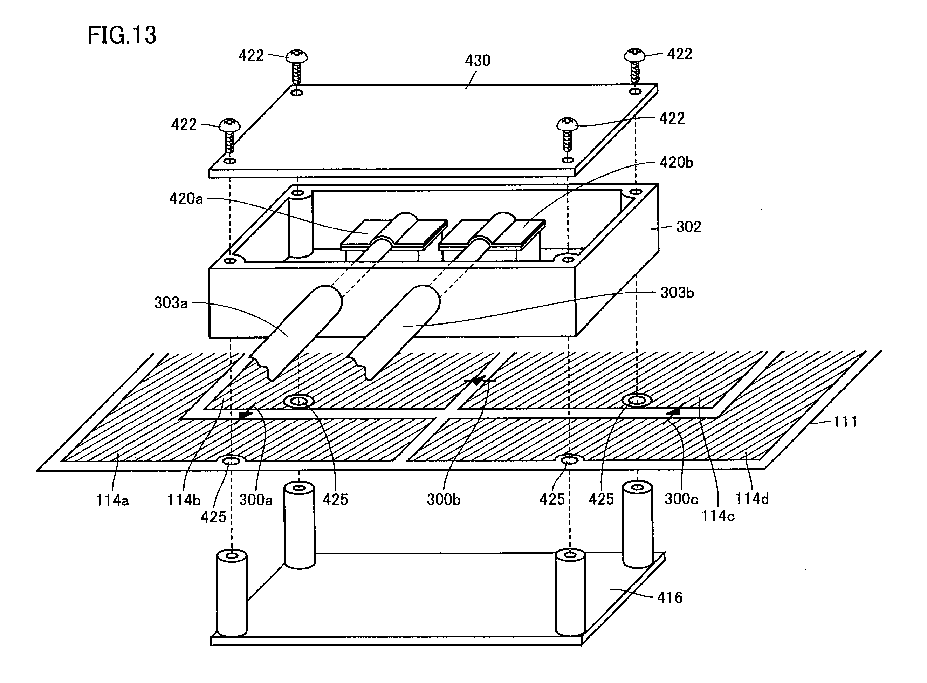

Here, the solar cell module configured as shown in Fig. 12 can be fabricated by, for example, providing through holes 425 in portions of the wiring substrate, inserting the projecting portions of screw receiving member 416 into terminal box 302 and terminal box cover member 430 via through holes 425, and turning screws 422 into the projecting portions of screw receiving member 416 for fixation, as shown in a schematic perspective view of Fig. 13.

In the solar cell module configured as shown in Fig. 12, since output terminals 310a, 310b in terminal box 302 can be physically pressed and bonded to and be therefore electrically connected to the output terminal connecting wires by fixing terminal box 302 to the wiring substrate by means of screwing, terminal box 302 can be readily and securely attached irrespective of levels of skill of operators.

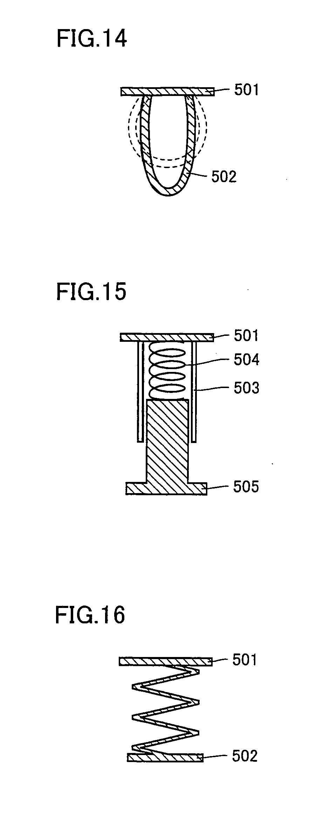

In the case where the output terminal connecting wires of the wiring substrate and the output terminals of the terminal box are connected by physical pressure bonding, each of the output terminals of the terminal box preferably has an elastic structure as illustrated in Figs. 14-16, for example.

For example, an output terminal shown in Fig. 14 is configured so that a U-shaped conductive elastic body 502 is joined to a conductive support 501. With such a configuration, when the output terminal of the terminal box is pressed against an output terminal connecting wire of the wiring substrate, elastic body 502 is deformed to have a shape shown by a broken line of Fig. 14. On this occasion, elastic body 502 has stress generated therein to bring the deformed elastic body 502 into its original shape. By the stress, the output terminal of the terminal box is physically pressed and bonded to the output terminal connecting wire of the wiring substrate.

Meanwhile, an output terminal shown in Fig. 15 is configured so that a conductive pressure bonding portion 505 is installed using a cylindrical conductive cover portion 503 joined to the surface of conductive support 501, and a conductive spring 504 provided within conductive cover portion 503. With such a configuration, when pressing the output terminal of the terminal box against the output terminal connecting wire of the wiring substrate, spring 504 contracts. On this occasion, spring 504 thus having contracted has stress generated therein to bring it back to its original shape. By the stress, the output terminal of the terminal box is physically pressed and bonded to the output terminal connecting wire of the wiring substrate.

Meanwhile, an output terminal shown in Fig. 16 is configured so that a conductive elastic body 502 joined to a surface of a conductive support 501 has a shape of spring. With such a configuration, when the output terminal of the terminal box is pressed against the output terminal connecting wire of the wiring substrate, elastic body 502 contracts. On this occasion, elastic body 502 thus having contracted has stress generated therein to bring it back to its original shape. By the stress, the output terminal of the terminal box is physically pressed and bonded to the output terminal connecting wire of the wiring substrate.

Among these, the structure shown in Fig. 14 or the structure shown in Fig. 16, each of which readily provides the output terminal with a large cross section, are particularly preferable because the output terminal of the terminal box intensively receives electric power in the solar cell module.

For such physical pressure bonding, a wiring substrate having smaller irregularities than those of a conventional wiring material is beneficial because it provides a stable contact. In the present invention, particularly, wire ends 114a, 114d occupy large areas, so the positions of the wire ends and the positions of the output terminals of the terminal box can be readily aligned with one another, thus providing good workability.

Meanwhile, exemplary methods for achieving the connections using a conductive material are to perform conventional and general soldering; to provide a conductive material such as a conductive adhesive agent or an ACF (Anisotropic Conductive Film) between the surface of wire end 114a and the output terminal and/or between the surface of wire end 114d and the output terminal in order to fix them together; and the like.

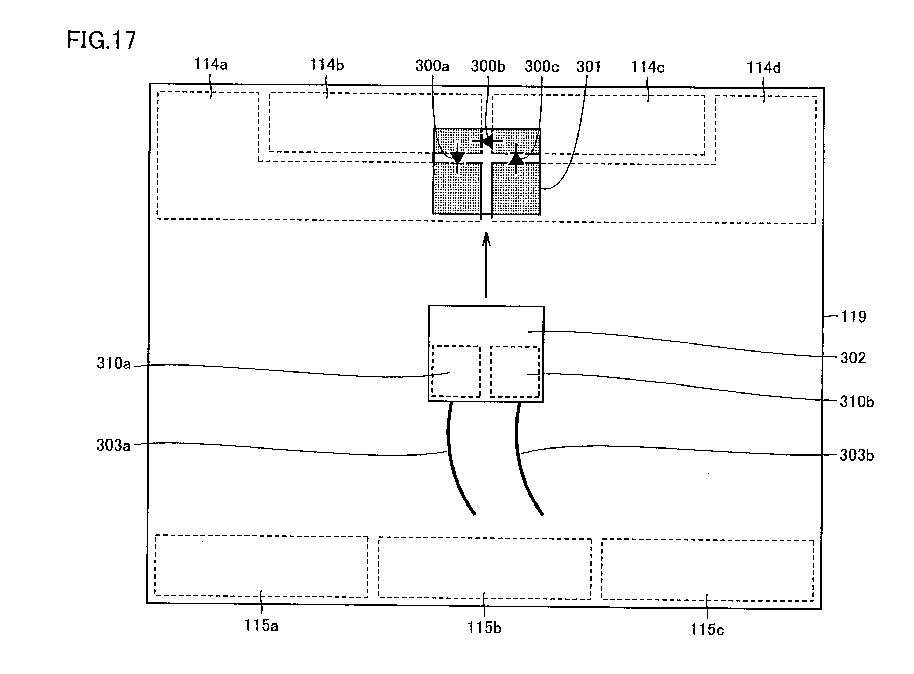

Fig. 17 shows a schematic plan view of another exemplary back surface side of a solar cell module fabricated by folding the solar battery structure that will constitute the solar cell module shown in Fig. 1 and sealing it with a sealing material. In this example, wire ends 114a, 114b, 114c, 114d and by-pass diodes 300a, 300b, 300c are provided to expose their portions from an opening 301 having a rectangular shape. Thus, in this example, by-pass diodes 300a, 300b, 300c can be connected to the solar cell string connecting wires after sealing the solar battery structure with the sealing material, thus allowing for a stable operation. Further, by attaching one terminal box 302 including lead wire 303a, lead wire 303b, output terminal 310a, and wire end 310b, not only wiring for extracting a current from the solar cell module can be accomplished but also diodes 300a, 300b, 300c can be protected by terminal box 302.

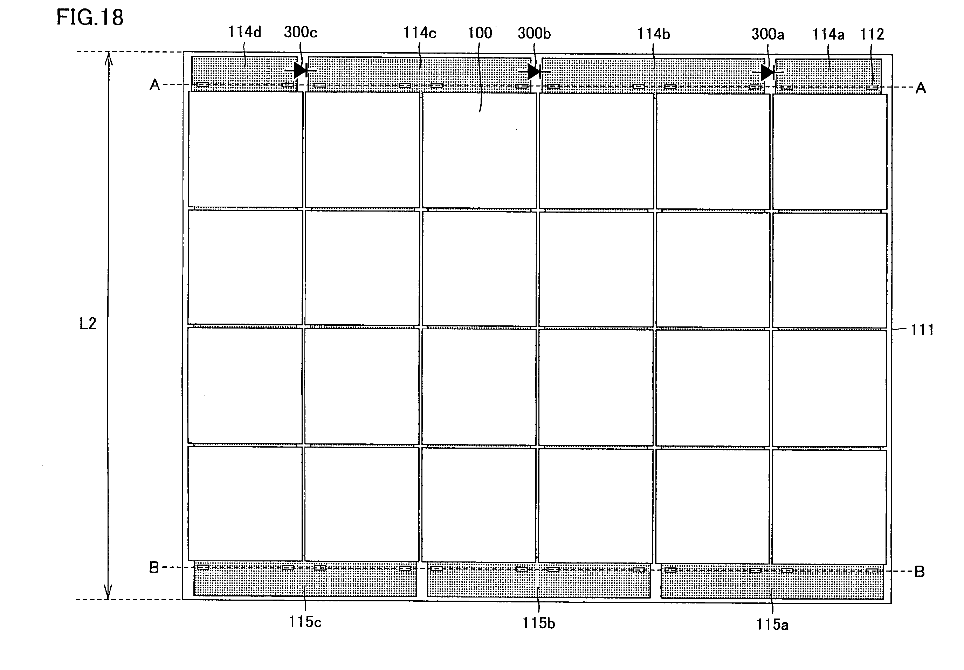

Fig. 18 shows a schematic plan view of another exemplary light receiving surface side before folding the solar battery structure that will constitute the solar cell module of the present invention.

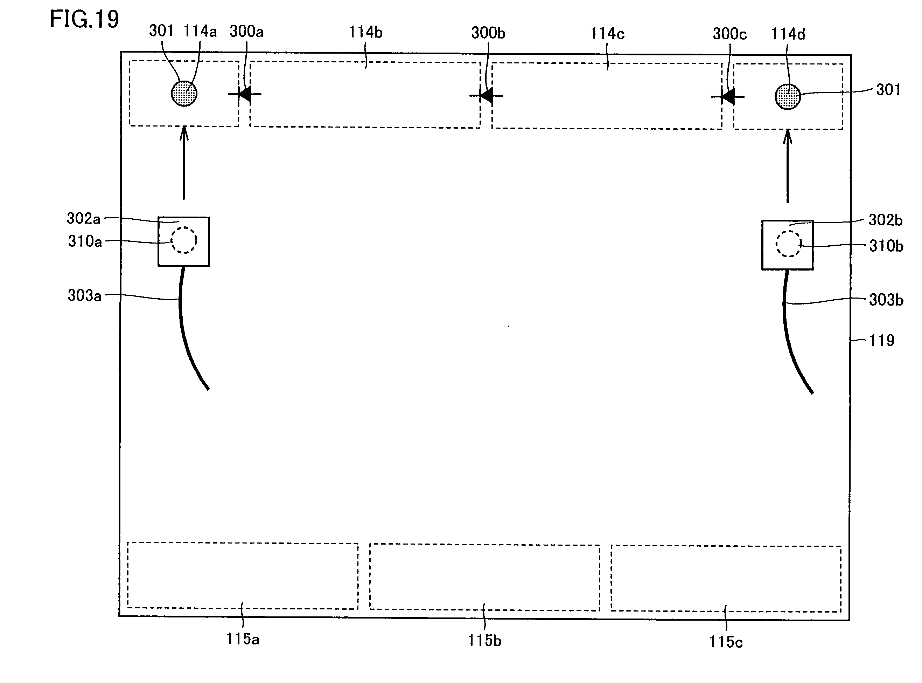

Fig. 19 shows a schematic plan view of an exemplary back surface side of a solar cell module fabricated by folding the solar battery structure shown in Fig. 18 along broken line A-A and broken line B-B and sealing it with a sealing material. In this example, separate terminal boxes are provided at two locations for positive or negative electrodes, respectively. With such a configuration, each terminal box can be small and the wires do not need to be converged to one location, i.e., one terminal box, thereby simplifying the wiring structure in the wiring substrate. This also permits utilization of a shorter cable for connecting adjacent solar cell modules.

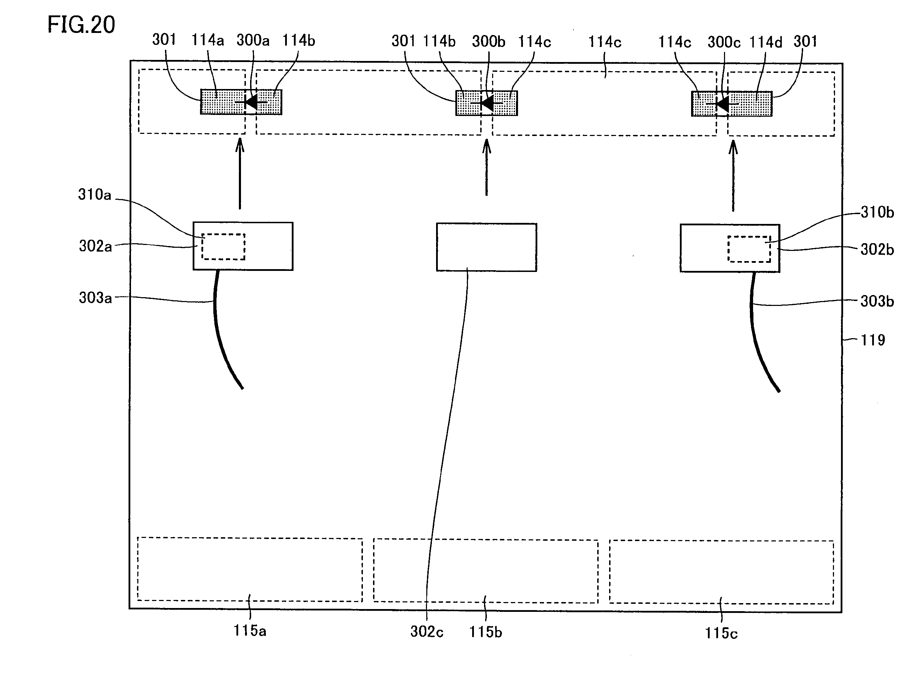

Fig. 20 shows a schematic plan view of another exemplary back surface side of a solar cell module fabricated by folding the solar battery structure shown in Fig. 18 along broken line A-A and broken line B-B and sealing it with a sealing material. A feature of this example lies in that openings 301 each having a rectangular shape are provided to expose diodes 300a, 300b, 300c therefrom. Thus, in this example, the by-pass diodes can be connected to the solar cell string connecting wires of the wire ends after sealing the solar battery structure, thus achieving improved operation stability.

Further, in this example, by-pass diode 300a is protected by electrically connecting output terminal 310a of terminal box 302a to the output terminal connecting wire of wire end 114a exposed from opening 301 and by containing by-pass diode 300a in terminal box 302a.

Further, in this example, by-pass diode 300b exposed from opening 301 is protected by containing by-pass diode 300b in a diode protection box 302c.

Further, in this example, by-pass diode 300c is protected by electrically connecting output terminal 310b in terminal box 302b to wire end 114d exposed from opening 301 and by containing by-pass diode 300c in terminal box 302b.

It should be noted that, in this specification, each of the surfaces of the back-side electrode type solar cell and the solar cell module via which sun light enters is defined as the "light receiving surface", whereas the surface opposite to the light receiving surface is defined as the "back surface".

Further, in the present invention, it is preferable to use as the solar cell a back-side electrode type solar cell in which both an electrode for p type and an electrode for n type are formed on the back surface of a semiconductor substrate such as a silicon substrate as described above.

Furthermore, in the present invention, a semiconductor substrate other than the silicon substrate may be used, and the conductivity types of p type and n type may be interchanged.

Further, although no by-pass diode (diode) is provided in the terminal box(s) in the description above, no diode may be provided on the wiring substrate and a by-pass diode (diode) may be formed in advance in the terminal box.

### Second Embodiment

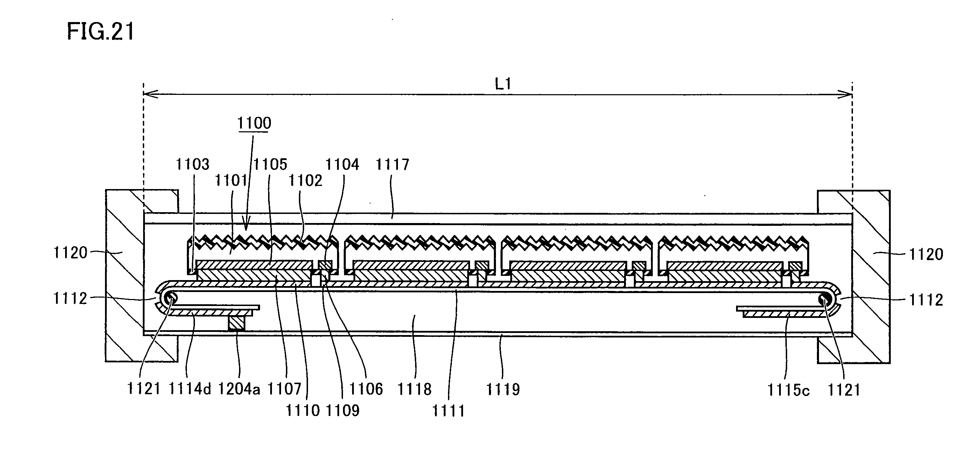

Fig. 21 shows a schematic cross sectional view of one exemplary solar cell module of the present invention. Here, the solar cell module of the present invention has back-side electrode type solar cells 1100 each configured, for example, as follows. A p type or n type silicon substrate 1101 has a back surface on which a passivation film 1103 is formed. At the surface thereof exposed from passivation film 1103, an n type region 1104 and a p type region 1105 are formed. Provided on n type region 1104 is an electrode 1106 for n type. Provided on p type region 1105 is an electrode 1107 for p type. Silicon substrate 1101 has a light receiving surface on which an anti-reflection film 1102 is formed. It should be noted that the light receiving surface of silicon substrate 1101 has a texture structure.

Electrode 1106 for n type and electrode 1107 for p type in back-side electrode type solar cell 1100 are respectively electrically connected to a wire 1109 for n type and a wire 1110 for p type on insulating base 1111. Electrode 1106 for n type in one of adjacent back-side electrode type solar cells 1100 is electrically connected to electrode 1107 for p type of the other back-side electrode type solar cell 1100, whereby adjacent back-side electrode type solar cells 1100 are connected in series to constitute a solar battery structure.

The solar battery structure is sealed with a sealing material 1118 between a transparent base 1117 formed of glass and a back-side base 1119 formed of a weather-resistant film, for example. The solar battery structure preferably has a wiring substrate folded at its opposite ends of the direction in which back-side electrode type solar cells 1100 are connected. Upon folding the wiring substrate, for improved workability, it is preferable to provide slits 1112 in the portions to be folded in advance and fold it around insulating bars 1121. In the present invention, any material can be used as sealing material 1118 without particular limitations, and an insulating transparent resin such as EVA (ethylene vinyl acetate) can be used for example.

By folding the opposite ends of the solar battery structure, a wire end 1114d and a wire end 1115c are positioned at a side opposite to the light receiving surface of back-side electrode type solar cell 1100. Of these wire ends, wire end 1114d is electrically connected to one end 1204a of a conductive wire for extracting a generated current from the solar cell module to outside. A frame body 1120 made of aluminum or the like is provided to surround the outer circumferences of transparent base 1117, sealing material 1118, and back-side base 1119, each sealing the solar battery structure, thereby fitting them in frame body 1120.

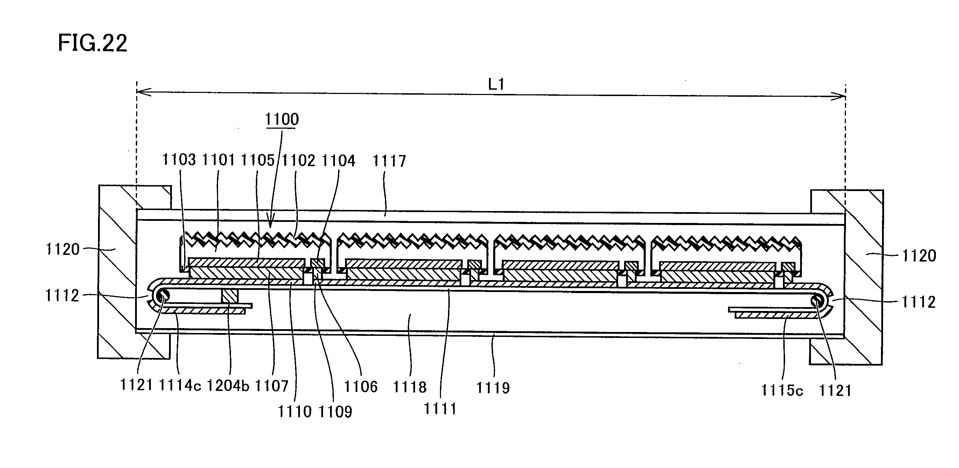

Fig. 22 schematically shows a cross section of the solar cell module at an inner side relative to the cross section thereof shown in Fig. 21. In Fig. 22, a conductive wire intermediate portion 1204b is shown between one end 1204a of the above-described conductive wire and the other end (not shown in the figure) of the conductive wire. Conductive wire intermediate portion 1204b is disposed to be enclosed by a folded portion of insulating base 1111.

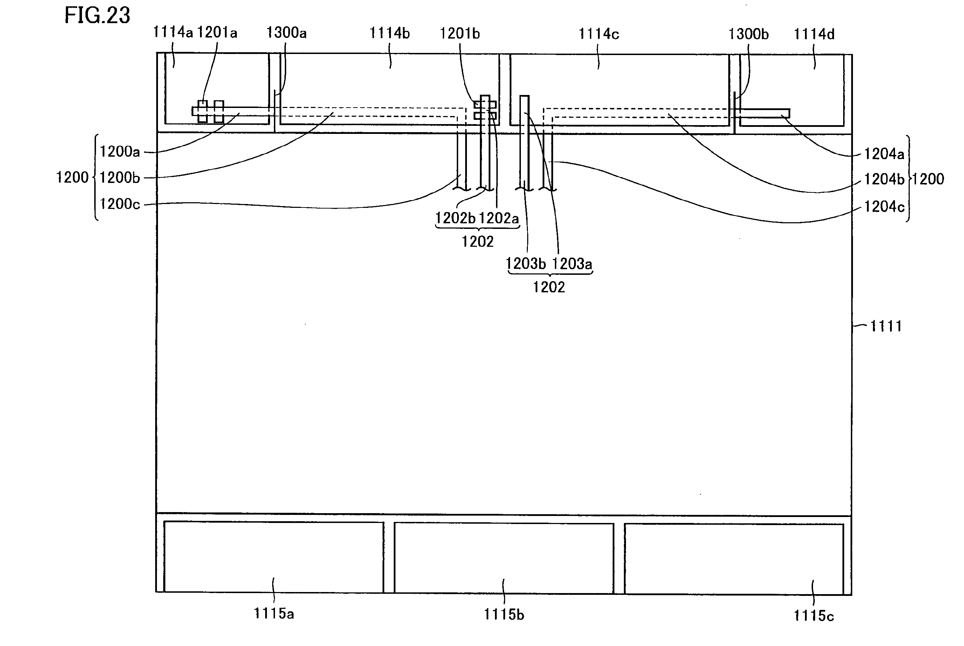

Fig. 23 shows a schematic plan view of an exemplary back surface side after folding the wiring substrate of the solar battery structure used in the solar cell module of the present invention but before sealing it with the sealing material. Of the wires formed in insulating base 1111, wire ends 1114a, 1114b, 1114c, 1114d and wire ends 1115a, 1115b, 1115c are folded toward the back surface side. Here, one end 1200a of conductive wire 1200 for extracting a current to outside is preferably fixed onto wire end 1114a temporarily by means of an adhering member 1201 a such as an adhesive tape, and one end 1202a of a conductive wire 1202 is preferably fixed onto wire end 1114b temporarily by means of an adhering member 1201b such as an adhesive tape. Such temporal fixation prevents displacement of conductive wires 1200, 1202 in subsequent steps. Electric connections therebetween are achieved by vacuum pressure bonding upon the sealing with sealing material 1118. In this way, the step of soldering conductive wires 1200, 1202 in the conventional art can be omitted. It should be noted that one end 1204a of conductive wire 1200 and one end 1203 a of conductive wire 1202 can be temporarily fixed.

Further, each of the conductive wires and/or the wire ends is provided in advance with at least one selected from a group consisting of a low-temperature solder melted at a temperature equal to or lower than a process temperature upon the vacuum pressure bonding for the sealing with sealing material 1118; a conductive adhesive agent cured at a temperature equal to or lower than the process temperature upon the vacuum pressure bonding; and a conductive material, such as an ACF (Anisotropic Conductive Film), which achieves the connection at the process temperature and pressure upon the vacuum pressure bonding. In this way, concurrently with the vacuum pressure bonding, the conductive wires and the wire ends are connected, thus achieving simplified processes and secure connections. Also, as conventionally done, the conductive wires and the wire ends may be connected before the sealing with sealing material 1118, using at least one selected from a group consisting of the solder, the conductive adhesive agent, and the conductive material such as an ACF. Here, in this example, no insulating process is provided to external surfaces of conductive wires 1200 and 1202.

Intermediate portions 1200b, 1204b of conductive wires 1200 extend from one ends 1200a, 1204a of conductive wires 1200, goes into the folded portions of the wiring substrate via notches 1300a, 1300b provided in insulating base 1111, respectively, and are interposed by the folded portions in the wiring substrate. Accordingly, at least portions of the surfaces of intermediate portions 1200b, 1204b of conductive wire 1200 are covered with insulating base 1111.

Thereafter, intermediate portions 1200b, 1204b of conductive wire 1200 are bent at substantially a right angle in the folded portions of the wiring substrate, and are thereafter drawn out from the ends of the wiring substrate. From the ends thereof, the other ends 1200c, 1204c of conductive wires 1200 extend.

Further, one ends 1202a, 1203a of conductive wires 1202 are respectively connected to wire ends 1114b, 1114c, from which the other ends 1202b, 1203b thereof extend. Gaps are provided between the other ends 1200c, 1204c of conductive wires 1200 and the other ends 1202b, 1203b of conductive wires 1202. The gaps will be filled with insulating sealing material 1118 due to the sealing of the solar battery structure with sealing material 1118. Hence, they are not in contact with each other and are insulated.

As such, according to the present invention, unlike the conventional solar cell module, the surfaces of the conductive wires do not need to be subjected to an insulating process of covering the surfaces thereof with an insulating film or the like so as to prevent them from being in contact with the electrodes or other conductive wires provided on the back surface of the back-side electrode type solar cell. Thus, the insulating process steps can be reduced and materials used therefor can be reduced.

It should be noted that the other ends 1200c, 1204c of conductive wires 1200 and the other ends 1202b, 1203b of conductive wires 1202 are drawn out of the solar cell module, and are connected to, for example, a terminal box including a diode and the like.

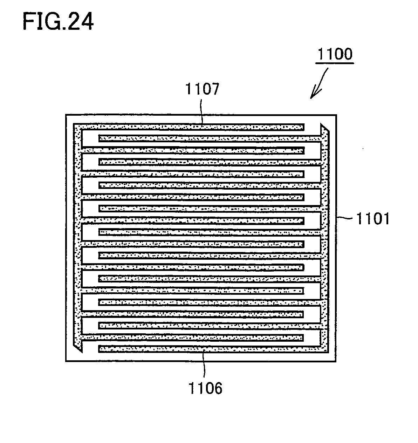

Fig. 24 shows a schematic plan view of the back surface of back-side electrode type solar cell 1100 used in the solar cell module. Here, each of electrode 1106 for n type and electrode 1107 for p type is formed on the back surface of silicon substrate 1101 in the form of a comb, and electrode 1106 for n type and electrode 1107 for p type are provided so that their comb tooth are engaged with one another and are positioned alternately. Here, each of electrode 1106 for n type and electrode 1107 for p type is preferably formed of a metal material, in particular, a material including silver.

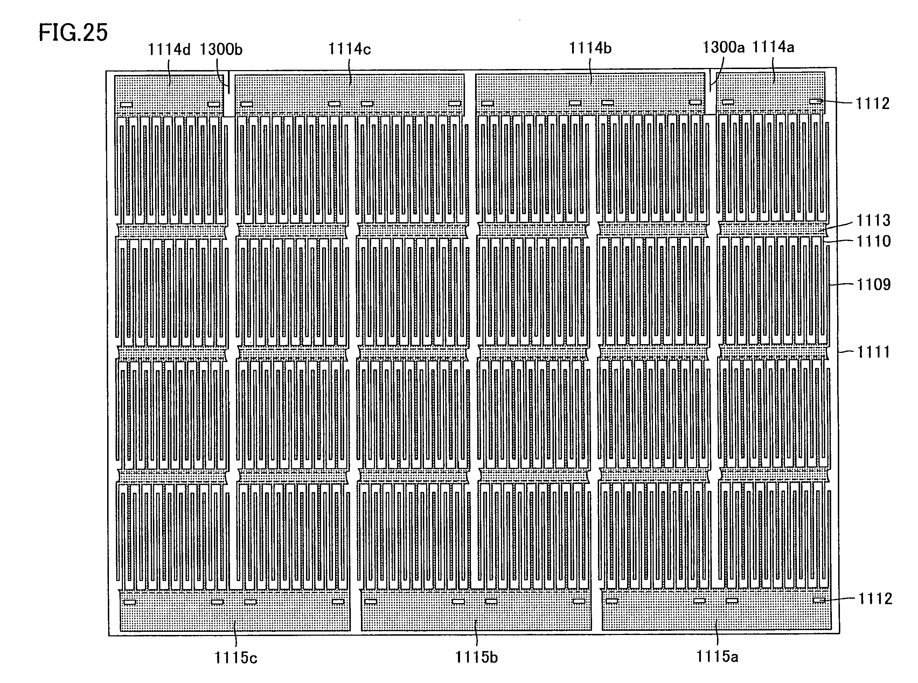

Fig. 25 shows a schematic plan view of the wiring substrate used in the solar cell module. Here, the wiring substrate, provided with wire 1109 for n type and wire 1110 for p type both disposed on the surface of insulating base 1111, includes a connecting wire 1113 for electrically connecting wire 1109 for n type to wire 1110 for p type. Wire 1109 for n type is electrically connected to electrode 1106 for n type in back-side electrode type solar cell 1100 whereas wire 1110 for p type is electrically connected to electrode 1107 for p type.

Further, wire 1110 for p type and wire 1109 for n type at the ends of the wiring substrate are electrically connected to any of wire ends 1114a, 1114b, 1114c, 1114d, 1115a, 1115b, 1115c. Thus, the wires are formed so that when connecting back-side electrode type solar cells 1100 thereto, they are connected in series as a whole.

Further, wire ends 1114a, 1114b, 1114c, 1114d and wire ends 1115a, 1115b, 11115c are provided with slits 1112, which are openings for positioning.

Further, notch 1300a is provided in insulating base 1111 between wire end 1114a and wire end 1114b, and notch 1300b is provided in insulating base 1111 between wire end 1114c and wire end 1114d.

It should be noted that in Fig. 25, the respective regions of wire 1109 for n type, wire 1110 for p type, connecting wire 1113, wire ends 1114a, 1114b, 1114c, 1114d, and wire ends 1115a, 1115b, 1115c are divided by broken lines but the way of dividing is not limited to the one shown in Fig. 25.

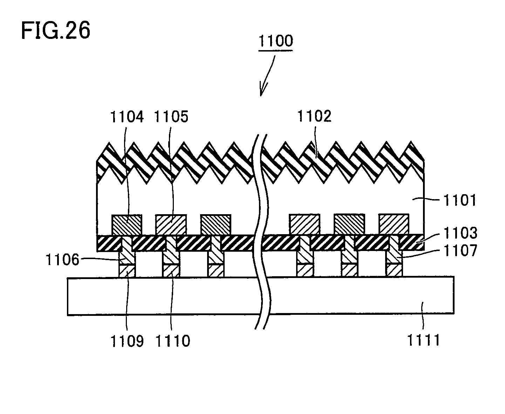

Fig. 26 shows a schematic cross sectional view of the solar battery structure in which back-side electrode type solar cells 1100 each having the back surface shown in Fig. 24 are electrically connected to the wiring substrate shown in Fig. 25.

Here, electrode 1106 for n type in each back-side electrode type solar cell 1100 is in contact with and is therefore electrically connected to wire 1109 for n type on the wiring substrate, and electrode 1107 for p type in back-side electrode type solar cell 1100 is in contact with and is therefore electrically connected to wire 1110 for p type on the wiring substrate.

As such, in the present invention, by attaching the wiring substrate onto the back surface of back-side electrode type solar cell 1100, electric connection therebetween is achieved. Accordingly, unlike the connection in the conventional solar cell, no interconnector needs to be drawn from the light receiving surface to the back surface, thereby achieving reduced load on back-side electrode type solar cell 1100 upon fabricating the solar cell module. Accordingly, back-side electrode type solar cell 1100 is less likely to be cracked. Since the present invention thus allows for reduced load on back-side electrode type solar cell 1100 upon fabricating the solar cell module, back-side electrode type solar cell 1100 can be thinner (the thickness of silicon substrate 101 can be 200 µm or smaller).

Further, degree of freedom in design for wiring in the wiring substrate is improved by folding, to the side opposite to the light receiving surface of back-side electrode type solar cell 1100, the ends of the wiring substrate where wire ends 1114a, 1114b, 1114c, 1114d and wire ends 1115a, 1115b, 1115c are formed and then by sealing the solar battery structure with the sealing material. In this way, the wire ends have large widths and thus have large cross sections, thereby reducing series resistance between back-side electrode type solar cells 1100. Thus, a solar cell module with a high F.F. can be fabricated.

In order to reduce the series resistance between back-side electrode type solar cells 1100 by providing the wire ends with large widths, a conductive member may be electrically connected to each of wire ends 1114a, 1114b, 1114c, 1114d and wire ends 1115a, 1115b, 1115c, at which the direction in which back-side electrode type solar cells 1100 are connected is turned. As the conductive member, any member can be used without particular limitations as long as it is made of a material having conductivity, for example, a conventionally known interconnector having been used in the field of solar cell may be used.

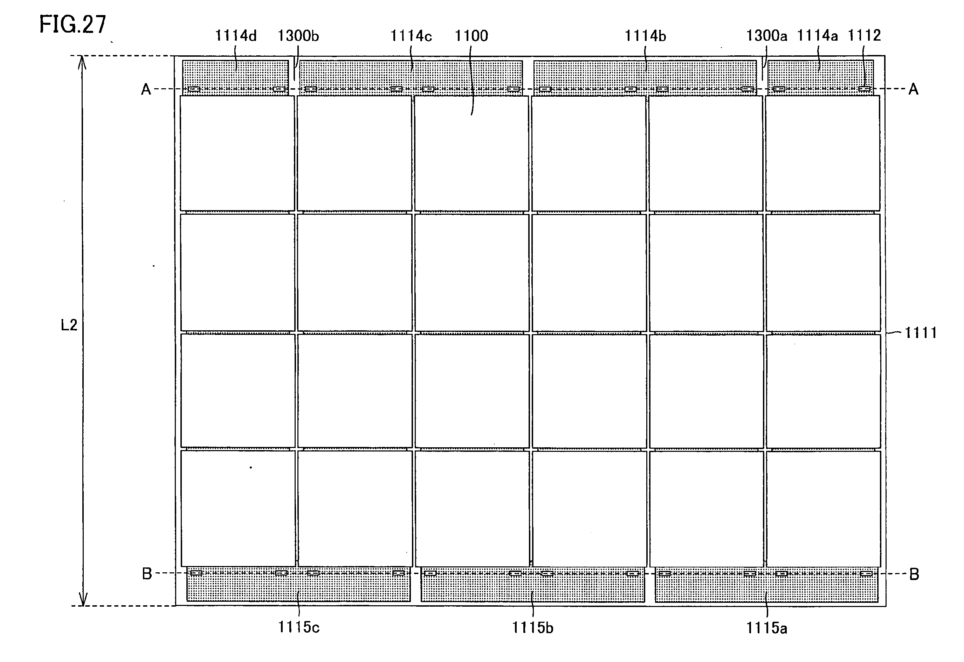

Fig. 27 shows a schematic plan view of one exemplary light receiving surface side before folding the solar battery structure constituting the solar cell module described above.

In this example, twenty four back-side electrode type solar cells 1100 are disposed 6 in column × 4 in row on the wires of the wiring substrate to constitute the solar battery structure. The wiring substrate is folded along a broken line A-A and a broken line B-B both corresponding to slits 1112 provided at the ends of the wiring substrate, and is sealed with the sealing material, thus obtaining the solar cell module configured as above.

Here, back-side electrode type solar cells 1100 arranged between wire end 1114a and wire end 1115a, between wire ends 1115a and wire end 1114b, between wire end 1114b and wire end 1115b, between wire end 1115b and wire end 1114c, between wire end 1114c and wire end 1115c, and between wire end 1115c and wire end 1114d are electrically connected to their adjacent back-side electrode type solar cells 1100 in series.

Because each of the wires is provided with a large cross section in order to reduce connection resistance in the solar cell module, a length L2 of the solar battery structure before the folding may be longer than a length L1 of the solar cell module. Length L2 is a length in the direction in which back-side electrode type solar cells 1100 of the solar battery structure shown in Fig. 27 are connected whereas length L1 is a length in the direction in which back-side electrode type solar cells 1100 shown in Fig. 21 are connected.

Even in such a case, however, in the present invention, the portions of the wiring substrate at the opposite ends of the solar battery structure are folded to the side opposite to the light receiving surface of each of back-side electrode type solar cells 1100 and then the solar battery structure is then sealed to fabricate the solar cell module, thereby improving an occupation rate, which is a rate of the total areas of the light receiving surfaces of back-side electrode type solar cells 1100 to the area of the light receiving portion of the solar cell module. Accordingly, power generation efficiency of the solar cell module can be improved. Further, in the present invention, the widths of the wires in the wiring substrate are widened to achieve reduced connection resistance, so characteristics of the solar cell module such as F.F. can be improved too.

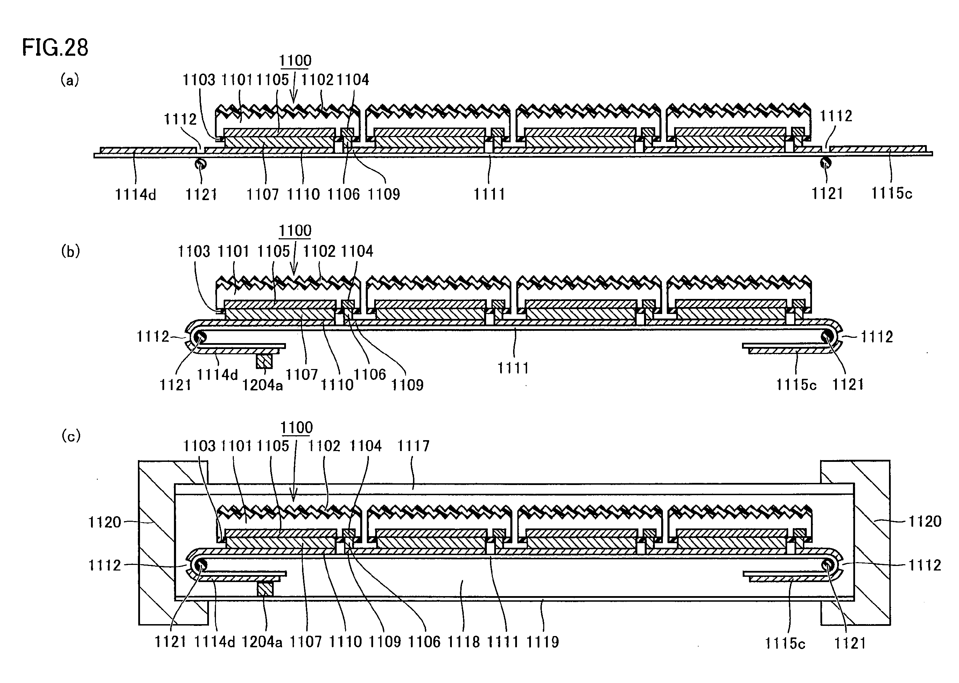

The following describes one exemplary method for manufacturing the solar cell module, with reference to schematic cross sectional views of Fig. 28(a)-Fig. 28(c).

First, as shown in Fig. 28(a), the solar battery structure is fabricated in the manner described above, and insulating bars 1121 are provided below slits 1112 formed at the opposite ends of the solar battery structure. As insulating bars 1121, there can be used bars each made of an insulating material such as acrylic and having a diameter of approximately 1-2 mm, for example. For prevention of cracks taking place in back-side electrode type solar cells 1100, bars 1121 are preferably provided, for example, outside back-side electrode type solar cells 1100 disposed at the ends in the direction in which back-side electrode type solar cells 1100 are connected, as shown in Fig. 28(a). Slits 1112 are preferably formed to have a size that has no influence over resistance of the wires in the wiring substrate.

Next, as shown in Fig. 28(b), one end 1204a of wire 1200 is connected to wire end 1114d of the wiring substrate, and thereafter the portions of insulating base 1111 of the wiring substrate at the opposite ends of the solar battery structure are folded around bars 1121 to the side opposite to the light receiving surface of back-side electrode type solar cell 1100. Here, the wiring substrate is folded to enclose a portion of wire 1200 extending from notch 1300b provided in insulating base 1111.

By folding in this way, the occupation rate can be improved which is a rate of the total area of the light receiving surfaces of back-side electrode type solar cells 1100 to the area of the light receiving portion of the solar cell module. Accordingly, power generation efficiency of the solar cell module can be improved. Further, conductive wires 1200 and 1202 may be connected before folding the wiring substrate or after folding the wiring substrate.

Further, in the embodiment described herein, bars 1121 are provided at the locations of slits 1112 as the folding locations, and the portions of the wiring substrate at the ends of the solar battery structure are folded around bars 1121. In the present invention, however, the wiring substrate may be folded without bars 1121 at the locations of slits 1112 as the folding locations, to the side opposite to the light receiving surface of back-side electrode type solar cell 1100. However, in the case where it is folded without using bars 1121, the folded portions provide acute angles, which may break the wires. In contrast, when folding around bars 1121, load on the folded portions is reduced. Thus, it is preferable to use bars 1121 and fold it around bars 1121. It should be noted that bars 1121 may be removed upon sealing the solar battery structure or may be remained therein.

After the portions of the wiring substrate at the opposite ends of the solar battery structure are thus folded to the side opposite to the light receiving surface of back-side electrode type solar cell 1100, the solar battery structure is sealed with sealing material 1118 such as a transparent resin between transparent base 1117 such as glass and back-side base 1119 such as a weather-resistant film, as shown in Fig. 28(c). Thereafter, frame body 1120 made of aluminum or the like is provided to surround the outer circumferences of transparent base 1117, sealing material 1118, and back-side base 1119, thereby fitting them in frame body 1120. In this way, the solar cell module configured as above is fabricated. Here, the solar battery structure is sealed with sealing material 1118 so that surfaces of intermediate portions 1200b, 1204b of conductive wires 1200 are covered with at least one of insulating base 1111 and sealing material 1118 and the other ends 1200c, 1202b, 1203b, 1204c of conductive wires 1200, 1202 are drawn out of sealing material 1118.

As insulating base 1111, any insulating base can be used without particular limitations but it is preferable to use an insulating base such as a flexible film formed of at least one selected from a group consisting of PET (polyethylene terephthalate), PEN (polyethylene naphthalate), polyimide, and ethylene vinyl acetate. In the case where the insulating base such as the flexible film is used as insulating base 1111, at least one of the opposite ends of the wiring substrate can be folded readily.

Further, it is preferable to use a metal material including at least one selected from a group consisting of silver, copper, and aluminum, for each of the wiring members described above, i.e., wire 1109 for n type, wire 1110 for p type, connecting wire 1113, wire ends 1114a, 1114b, 1114c, 1114d, and wire ends 1115a, 1115b, 1115c.

Further, in the present invention, it is preferable to use as the solar cell a back-side electrode type solar cell in which both an electrode for p type and an electrode for n type are formed on the back surface of a semiconductor substrate such as a silicon substrate as described above.

Furthermore, in the present invention, a semiconductor substrate other than a silicon substrate may be used, and the conductivity types of p type and n type may be interchanged.

### Third Embodiment

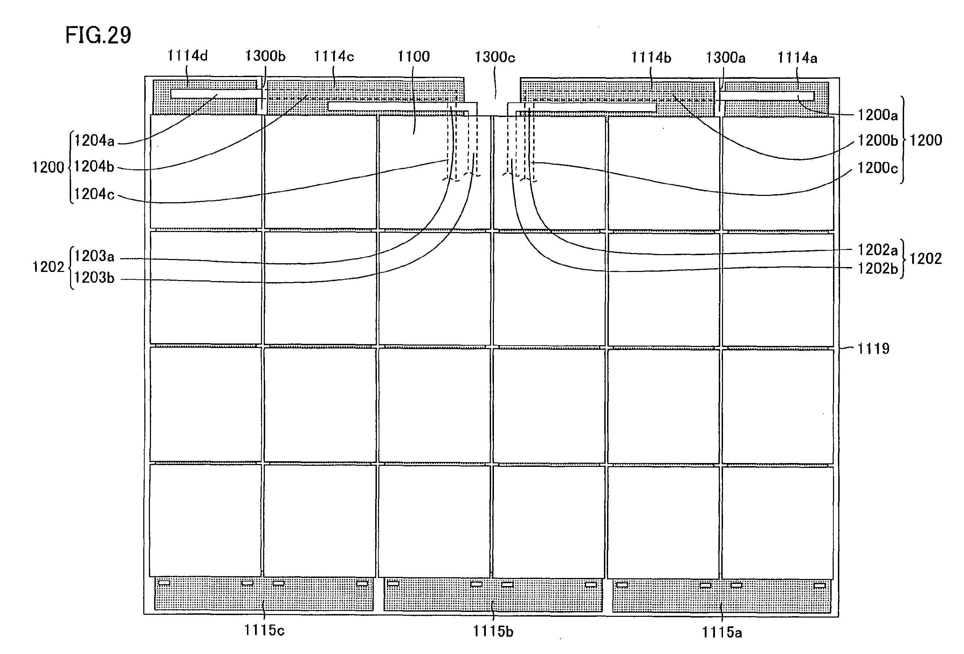

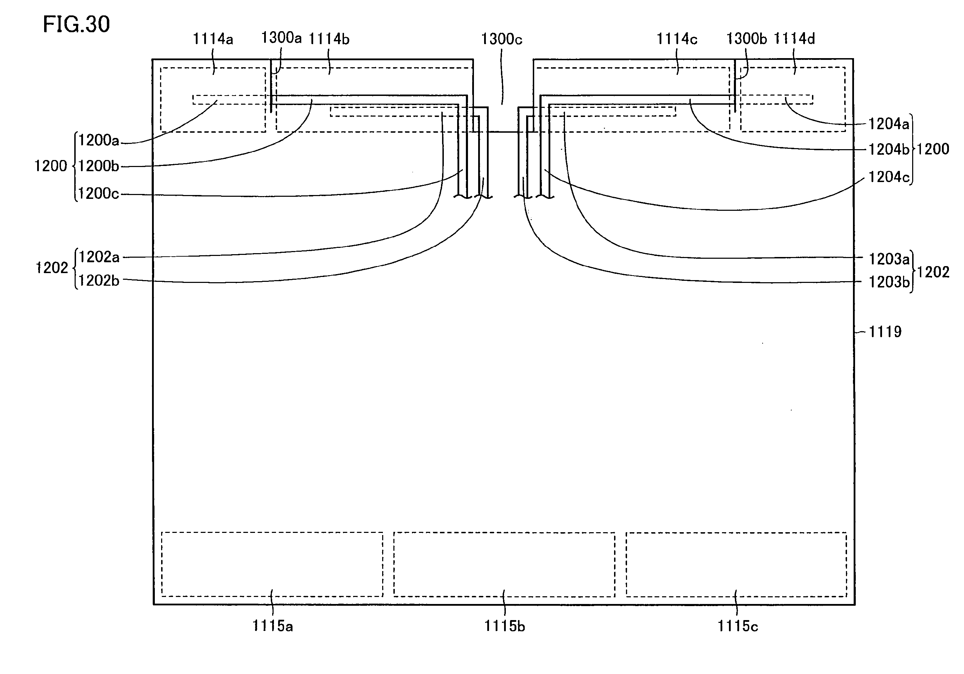

Fig. 29 shows a schematic plan view when viewing a portion of an exemplary solar cell module of the present invention from the light receiving surface side. Fig. 30 shows a schematic plan view when viewing the portion of the solar cell module of Fig. 29 from the back surface side. A feature of this example lies in that the ends of the solar battery structure are not folded and sealed with a sealing material. For ease of illustration, in Fig. 29 and Fig. 30, a transparent base 1117, a sealing material 1118, and a frame body 1120 are not shown.

Here, one end 1200a of a conductive wire 1200 for extracting to the outside a current generated in the solar cell module is connected onto a wire end 1114a by means of a solder or like, and one end 1204a of a conductive wire 1200 is connected onto wire end 1114d by means of a solder or the like. It should be noted that the connections may be achieved by the same methods as those described in the first embodiment, apart from the soldering.

From one end 1200a of conductive wire 1200, an intermediate portion 1200b of conductive wire 1200 extends and goes into the back side of the wiring substrate via a notch 1300a provided in insulating base 1111, and is bent at a substantially right angle in the back side of the wiring substrate. Similarly, from one end 1204a of conductive wire 1200, an intermediate portion 1204b of conductive wire 1200 extends and goes into the back side of the wiring substrate via a notch 1300b provided in insulating base 1111, and is bent at a substantially right angle in the back side of the wiring substrate. From intermediate portion 1200b of conductive wire 1200, the other end 1200c of conductive wire 1200 extends.

Further, one ends 1202a, 1203a of conductive wires 1202 for extracting a current to the outside are fixed onto wire end 1114b and wire end 1114c by means of a solder or the like as with those described above. Conductive wires 1202 are bent at a substantially right angle, and extend to the back side of insulating base 1111 via a notch 1300c. From there, the other ends 1202b, 1203b of conductive wires 1202 extend respectively.

Even though the respective surfaces of conductive wires 1200 and conductive wires 1202 are not subjected to an insulating process, conductive wires 1200 and wire ends 1114b, 1114c can be prevented from being in contact with each other, by extending conductive wires 1200 to the back side of the wiring substrate via notches 1300a, 1300b provided in insulating base 1111. Further, conductive wires 1200, 1202 and back-side electrode type solar cell 1100 are prevented from being in contact with each other, due to insulating base 1111 provided therebetween. Further, gaps are provided between the other ends 1200c, 1204c of conductive wires 1200 and the other ends 1202b, 1203b of conductive wires 1202, and the gaps will be filled with insulating sealing material 1118 after the sealing of the solar battery structure with sealing material 1118, whereby they can be prevented from being in contact with each other and can be insulated.

As such, also in this example, the respective external surfaces of conductive wires 1200, 1202 for extracting a generated current from the solar cell module to the outside are covered with at least one of insulating base 1111 and sealing material 1118 within the solar cell module, so conductive wires 1200, 1202 can be prevented from being electrically connected to each other in the solar cell. Accordingly, the external surfaces of conductive wires 1200, 1202 do not need to be subjected to an insulating process. Thus, also in this example, the insulating members constituting the solar cell module can be employed to electrically insulate conductive wires 1200, 1202 from each other. This eliminates need for an extra insulating process for the respective surfaces of conductive wires 1200, 1202. Thus, the conductive wires can be insulated in a simplified manner. Other explanation for the third embodiment is the same as that for the second embodiment.

Although the embodiments of the present invention have been described, it should be considered that the embodiments disclosed herein are illustrative and non-restrictive in any respect. The scope of the present invention is defined by the scope of claims, and is intended to include any modifications within the scope and meaning equivalent to the terms of the claims.

### INDUSTRIAL APPLICABILITY

According to the present invention, a solar cell module allowing for a simplified wiring operation and a method for manufacturing such a solar cell module can be provided.

Further, according to the present invention, a solar cell module allowing for a simplified insulating process for a conductive wire and a method for manufacturing such a solar cell module can be provided.

## Claims

1. A solar cell module comprising a solar battery structure including a wiring substrate having a wire (109, 110, 1109, 1110) for electrically connecting solar cells (100, 1100), and a plurality of solar cells (100, 1100) disposed on said wire (109, 110, 1109, 1110) of said wiring substrate and electrically connected to one another,
said solar battery structure being disposed in a sealing material (118, 1118) such that said solar battery structure has opposite ends in at least one of which a portion of said wire (109, 110, 1109, 1110) is located at a side opposite to light receiving surfaces of said solar cells (100, 1100),
at least one portion of said wire (109, 110, 1109, 1110) thus located at the side opposite to the light receiving surfaces of said solar cells (100, 1100) being exposed from said sealing material (118, 1118).

2. The solar cell module according to claim 1, wherein said wire (109, 110, 1109, 1110) has at least one portion including at least one selected from a group consisting of copper, aluminum, and silver.

3. The solar cell module according to claim 1, comprising a plurality of solar cell strings in each of which said solar cells (100, 1100) are connected in series in a row; and a terminal box (302, 302a, 302b) having an output terminal (310a, 310b) for extracting to outside a current generated in said solar battery structure, wherein
said wire (109, 110, 1109, 1110) of said wiring substrate includes a solar cell string connecting wire to which said solar cell strings are connected, and an output terminal connecting wire to which said output terminal (310a, 310b) is connected.

4. The solar cell module according to claim 3, comprising a by-pass diode connected to said solar cell string connecting wire.

5. The solar cell module according to claim 3, wherein said output terminal connecting wire and said output terminal (310a, 310b) are connected to each other by at least one of physical pressure bonding and utilization of a conductive material.

6. The solar cell module according to claim 5, wherein said output terminal connecting wire and said output terminal (310a, 310b) are connected to each other through physical pressure bonding employing magnetic force.

7. The solar cell module according to claim 5, wherein said output terminal connecting wire and said output terminal (310a, 310b) are connected to each other through physical pressure bonding achieved by fixing said terminal box (302, 302a, 302b) to said wiring substrate by means of screwing.

8. The solar cell module according to claim 1, wherein said wiring substrate has an insulating base (111, 1111) provided with said wire (109, 110, 1109, 1110), and said insulating base (111, 1111) is flexible and includes at least one selected from a group consisting of polyethylene terephthalate, polyethylene naphthalate, polyimide, and ethylene vinyl acetate.

9. The solar cell module according to claim 8, wherein a portion of said wiring substrate at at least one of the opposite ends of said solar battery structure is folded to position the portion of said wire (109, 110, 1109, 1110) at the side opposite to the light receiving surfaces of said solar cells (100, 1100).

10. The solar cell module according to claim 1, wherein each of said solar cells (100, 1100) is a back-side electrode type solar cell (100, 1100) having a back surface, which is opposite to the light receiving surface of said solar cell (100, 1100) and is provided with an electrode for p type (107, 1107) and an electrode for n type (106, 1106).

11. A method for manufacturing the solar cell module recited in claim 1, comprising the steps of:
electrically connecting said solar cells (100, 1100) to said wire (109, 110, 1109, 1110) of said wiring substrate so as to form said solar battery structure; and
disposing said solar battery structure in said sealing material (118, 1118) such that said at least one portion of said wire (109, 110, 1109, 1110) at at least one of the opposite ends of said solar battery structure is exposed from said sealing material (118, 1118) at the side opposite to the light receiving surfaces of said solar cells (100, 1100).

12. A solar cell module wherein:
a solar battery structure includes an insulating base (111, 1111) provided with a wire (109, 110, 1109, 1110) for electrically connecting solar cells (100, 1100) to one another, and a plurality of solar cells (100, 1100) disposed on said wire (109, 110, 1109, 1110) of said insulating base (111, 1111) and electrically connected to one another, and said solar battery structure is disposed in an insulating sealing material (118, 1118),
a conductive wire (1200, 1202) for extracting a current to outside has one end (1200a, 1202a, 1203a, 1204a) electrically connected to said wire (109, 110, 1109, 1110) and said conductive wire (1200, 1202) has the other end (1200c, 1202b, 1203b, 1204c) drawn to outside from said sealing material (118, 1118), and
at least one portion of a surface of said conductive wire (1200, 1202) between said one end (1200a, 1202a, 1203a, 1204a) of said conductive wire (1200, 1202) and the other end (1200c, 1202b, 1203b, 1204c) of said conductive wire (1200, 1202) is covered with at least one of said insulating base (111, 1111) and said sealing material (118, 1118).

13. The solar cell module according to claim 12, wherein:
said solar battery structure is disposed in said sealing material (118, 1118) such that at least one portion of said insulating base (111, 1111) at at least one of opposite ends of said solar battery structure is folded to a side opposite to light receiving surfaces of said solar cells (100, 1100), and
said at least one portion of the surface of said conductive wire (1200, 1202) between said one end (1200a, 1202a, 1203 a, 1204a) of said conductive wire (1200, 1202) and the other end (1200c, 1202b, 1203b, 1204c) of said conductive wire (1200, 1202) is interposed by the folded portion of said insulating base (111, 1111) and is therefore covered with said insulating base (111, 1111).

14. The solar cell module according to claim 12, wherein:
said at least one portion of the surface of said conductive wire (1200, 1202) between said one end (1200a, 1202a, 1203 a, 1204a) of said conductive wire (1200, 1202) and the other end (1200c, 1202b, 1203b, 1204c) of said conductive wire (1200, 1202) is covered with said sealing material (118, 1118), and
the other end (1200c, 1202b, 1203b, 1204c) of said conductive wire (1200, 1202) is drawn to outside via a notch (1300a, 1300b, 1300c) provided in said sealing material (118, 1118).

15. The solar cell module according to claim 12, wherein said wire (109, 110, 1109, 1110) has at least one portion including at least one selected from a group consisting of copper, aluminum, and silver.

16. The solar cell module according to claim 12, wherein said insulating base (111, 1111) is flexible and includes at least one selected from a group consisting of polyethylene terephthalate, polyethylene naphthalate, polyimide, and ethylene vinyl acetate.

17. The solar cell module according to claim 12, wherein each of said solar cells (100, 1100) is a back-side electrode type solar cell (100, 1100) having a back surface, which is opposite to a light receiving surface of said solar cell (100, 1100) and is provided with an electrode for p type (107, 1107) and an electrode for n type (106, 1106).

18. A method for manufacturing the solar cell module recited in claim 12, comprising the steps of:
electrically connecting said solar cells (100, 1100) to said wire (109, 110, 1109, 1110) of said insulating base (111, 1111) so as to form said solar battery structure;
electrically connecting said one end (1200a, 1202a, 1203a, 1204a) of said conductive wire (1200, 1202) to said wire (109, 110, 1109, 1110); and
sealing said solar battery structure with said sealing material (118, 1118) such that at least one portion of the surface of said conductive wire (1200, 1202) is covered with at least one of said insulating base (111, 1111) and said sealing material (118, 1118) and the other end (1200c, 1202b, 1203b, 1204c) of said conductive wire (1200, 1202) is drawn from said sealing material (118, 1118) to outside.
